(19) Europäisches Patentamt
European Patent Office
Office européen des brevets

(11) **EP 3 964 323 A1**

(12) **EUROPÄISCHE PATENTANMELDUNG**

(43) Veröffentlichungstag:
**09.03.2022 Patentblatt 2022/10**

(21) Anmeldenummer: **20194675.3**

(22) Anmeldetag: **04.09.2020**

(51) Internationale Patentklassifikation (IPC):
*B23K 26/53* (2014.01)    *B23K 26/06* (2014.01)
*B23K 26/073* (2006.01)    *B23K 26/0622* (2014.01)
*B81C 1/00* (2006.01)    *B23K 103/00* (2006.01)

(52) Gemeinsame Patentklassifikation (CPC):
**B23K 26/53; B23K 26/0624; B23K 26/0648;
B23K 26/0738; B81C 1/00595;** B23K 2103/54

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **SCHOTT AG
55122 Mainz (DE)**

(72) Erfinder:
• **Ortner, Andreas
55435 Gau-Algesheim (DE)**
• **Sohr, David
55120 Mainz (DE)**
• **Thomas, Jens Ulrich
55128 Mainz (DE)**

(74) Vertreter: **Fuchs Patentanwälte Partnerschaft
mbB
Westhafenplatz 1
60327 Frankfurt am Main (DE)**

(54) **VERFAHREN ZUM OBERFLÄCHENSTRUKTURIEREN EINES SUBSTRATKÖRPERS UND SUBSTRATKÖRPER**

(57) Die vorliegende Erfindung betrifft ein Verfahren zum Vorbereiten und/oder Durchführen der Strukturierung einer vorgegebenen oder vorgebbaren ausgezeichneten Oberfläche eines ein Substratmaterial aufweisenden Substratkörpers,

wobei das Verfahren aufweist, das Substratmaterial in wenigstens einem gekrümmten Wirkbereichen einem elektromagnetischen Feld auszusetzen, das in jedem des wenigstens einen gekrümmten Wirkbereichs eine nichtlineare Wechselwirkung zwischen dem elektromagnetischen Feld und dem Substratmaterial hervorruft, und so das in dem gekrümmten Wirkbereich angeordnete Substratmaterial zumindest teilweise zu beeinflussen,

wobei nach dem Strukturieren der ausgezeichneten Oberfläche die ausgezeichnete Oberfläche zumindest bereichsweise wenigstens einen ersten gekrümmten Verlauf aufweist, der durch die gekrümmte Gestalt des wenigstens einen gekrümmten Wirkbereichs zumindest teilweise bestimmt und/oder beeinflusst wird,

wobei die nichtlineare Wechselwirkung wenigstens eine nichtlineare Absorption des elektromagnetischen Feldes im Substratmaterial hervorruft, vorgeschlagen wird..

Die Erfindung betrifft außerdem einen Substratkörper.

Fig. 1

**Beschreibung**

Die vorliegende Erfindung betrifft ein Verfahren zum Vorbereiten und/oder Durchführen der Strukturierung einer Oberfläche eines Substratkörpers. Die Erfindung betrifft außerdem einen Substratkörper.

Stand der Technik

Um ein Ausgangssubstrat zu bearbeiten, so dass eine vorgegebene Oberfläche, wie eine Trennfläche, ausgebildet wird, sind im Stand der Technik Trennvorgänge durch Ritzen und Brechen, Rädchenschnitt, laserbasiertes thermisches Trennen, also mechanische Vorschädigung des Substrats und Führen eines Risses durch ein thermisches Spannungsfeld im Material, und laserbasiertes Perforationstrennen, also das Filamentieren entlang einer Kontur und anschließendes mechanisches oder thermisches Trennen entlang der Perforation, bekannt.

Allerdings sind diese Verfahren mit dem Nachteil behaftet, dass die vorgegebene Sollfläche häufig nicht erreicht wird. Dies liegt mitunter an den auch bewusst eingebrachten Vorschädigungen des Substratmaterials, die jedoch nicht ausreichend kontrolliert werden können.

Es ist daher Aufgabe der vorliegenden Erfindung, bei einem Substratkörper eine geplante Oberfläche zuverlässig ausbilden zu können.

Beschreibung der Erfindung

Die Aufgabe wird durch die Erfindung gemäß einem ersten Aspekt dadurch gelöst, dass ein Verfahren zum Vorbereiten und/oder Durchführen der Strukturierung einer vorgegebenen oder vorgebbaren ausgezeichneten Oberfläche eines ein Substratmaterial aufweisenden Substratkörpers,
wobei das Verfahren aufweist, das Substratmaterial in wenigstens einem gekrümmten Wirkbereichen einem elektromagnetischen Feld auszusetzen, das in jedem des wenigstens einen gekrümmten Wirkbereichs eine nichtlineare Wechselwirkung zwischen dem elektromagnetischen Feld und dem Substratmaterial hervorruft, und so das in dem gekrümmten Wirkbereich angeordnete Substratmaterial zumindest teilweise zu beeinflussen,
wobei nach dem Strukturieren der ausgezeichneten Oberfläche die ausgezeichnete Oberfläche zumindest bereichsweise wenigstens einen ersten gekrümmten Verlauf aufweist, der durch die gekrümmte Gestalt des wenigstens einen gekrümmten Wirkbereichs zumindest teilweise bestimmt und/oder beeinflusst wird,
wobei die nichtlineare Wechselwirkung wenigstens eine nichtlineare Absorption des elektromagnetischen Feldes im Substratmaterial hervorruft, vorgeschlagen wird.

Dies beruht auf der überraschenden Erkenntnis, dass die räumliche Ausdehnung des elektromagnetischen Feldes, mithin die Form der einzelnen gekrümmten Wirkbereiche, dazu ausgenutzt werden kann, die geplante Oberfläche zumindest in ihrem grundsätzlichen Verlauf vorzugeben.

Das Substratmaterial wird also einem elektromagnetischen Feld ausgesetzt. In wenigstens einem Bereich des elektromagnetischen Feldes, wobei der Bereich gekrümmt ist, findet eine nichtlineare Wechselwirkung zwischen dem elektromagnetischen Feld und dem Substratmaterial statt. Dadurch wird in diesem gekrümmten Bereich, der als gekrümmter Wirkbereich bezeichnet wird, das in diesem Bereich angeordnete Substratmaterial zumindest teilweise beeinflusst.

Diese Beeinflussung des Substratmaterials kann dabei beispielsweise als Volumenmodifikation im Substratmaterial verstanden werden. Die Art der Modifikation kann dabei etwa Risse, Hohlräume (Kavitäten) und/oder Änderungen der Struktur des Substratmaterials, die insbesondere einen schnelleren Ätzabtrag (gegenüber dem nicht beeinflussten Substratmaterial) zur Folge haben, aufweisen.

Beispielsweise kann dann auch eine Grenzfläche zwischen dem beeinflussten und dem unbeeinflussten Substratmaterial gefunden werden. Diese entspricht der Oberfläche des gekrümmten Wirkbereichs. Diese Grenzfläche kann ganz oder teilweise innerhalb des Substratmaterials verlaufen. Im Fall, dass durch die nichtlineare Wechselwirkung eine Kavität erzeugt wird, kann die Grenzfläche der Oberfläche der Kavität entsprechen.

Das unbeeinflusste Substratmaterial weist damit die komplementäre Form des gekrümmten Wirkbereichs auf. Oder mit anderen Worten, das unbeeinflusste Substratmaterial weist lokal eine Oberfläche auf, die formschlüssig mit der Oberfläche des beeinflussten Bereichs zusammenwirkt.

Indem diese Oberfläche des unbeeinflussten Substratmaterials freigelegt und/oder weiter bearbeitet wird, kann unter Erhaltung des aufgeprägten Verlaufes die ausgezeichnete Oberfläche bereitgestellt werden.

Die räumliche Ausbildung des gekrümmten Wirkbereichs ist sehr flexibel möglich, indem der Bereich, in dem das elektromagnetische Feld mit dem Substratmaterial nichtlinear wechselwirken kann, eine entsprechende Gestalt aufweist. Damit kann durch Kontrolle der Bereiche mit nichtlinearer Wechselwirkung über das elektromagnetische Feld die gekrümmten Wirkbereiche definiert und kontrolliert werden. Dadurch kann eine ausgezeichnete Oberfläche nicht nur außen am Substratkörper, sondern auch ganz oder teilweise innerhalb des Substratkörpers strukturiert werden.

In einer Ausführungsform wird eine nichtlineare Wechselwirkung dadurch erreicht, dass die Intensität des elektromagnetischen Feldes zumindest bereichsweise eine solche Intensität aufweist, die zu einer nichtlinearen Wechselwirkung mit dem Substratmaterial führt. Der gekrümmte Wirkbereich ist dann in den Volumenbereichen, in dem eine entsprechend hohe Intensität besteht.

Beispielsweise kann ein gekrümmter Wirkbereich vollständig innerhalb des Substrats ausgebildet werden. Oder er kann sich zumindest von einer Oberfläche des Substrats aus ins Innere des Substratkörpers erstrecken. Dabei kann der gekrümmte Wirkbereich auch bis zu einer anderen Oberfläche des Substratkörpers reichen. Alternativ oder ergänzend kann der gekrümmte Wirkbereich auch einen Schnitt mit einer weiteren Oberfläche, wie einer Seitenfläche, des (unstrukturierten) Substratkörpers aufweisen. Letzteres ist besonders interessant, wenn eine Seitenfläche des Substratkörpers strukturiert werden soll. Dann kann ein gekrümmter Wirkbereich so innerhalb des Substratmaterials ausgebildet werden, dass er von beispielsweise drei Seitenflächen des unstrukturierten Substratkörpers geschnitten wird.

Das Verfahren macht es folglich besonders einfach und effizient möglich, eine Strukturierung einer geplanten Oberfläche als ausgezeichnete Oberfläche des Substratkörpers vorzubereiten bzw. durchzuführen. Die Gestalt des beeinflussten Substratmaterials kann dabei nahezu beliebig gewählt werden. Es muss lediglich ein entsprechend geformtes elektromagnetisches Feld bereitgestellt werden bzw. bereitgestellt werden können, dem das Substratmaterial (lokal) ausgesetzt wird und mit dem es nichtlinear wechselwirken kann.

Unter dem Begriff "Strukturieren der ausgezeichneten Oberfläche" wird allgemein das Ausbilden einer bisher nicht vorhandenen Oberfläche des Substratkörpers verstanden. Dies kann beispielsweise durch Manipulieren einer bestehenden Oberfläche erfolgen, etwa indem letztlich Substratmaterial im Oberflächenbereich der bestehenden Oberfläche entfernt und dadurch die neue Oberfläche als ausgezeichnete Oberfläche ausgebildet wird. Dies kann auch beispielsweise durch das Abtrennen eines Teils des Substratmaterials von dem Substratkörper entlang einer geplanten Oberfläche und damit Freilegen der neuen Oberfläche als ausgezeichnete Oberfläche erfolgen. Selbstverständlich kann der Übergang fließend sein, wann noch eine bestehende Oberfläche manipuliert wird und wann schon ein Teil des Substratmaterials abgetrennt wird.

Allerdings ist die Unterscheidung insoweit auch nicht kritisch, da in beiden Fällen Substratmaterial des Substratkörpers mit dem Ziel beeinflusst wird, durch die Gestalt des gekrümmten Wirkbereichs den Verlauf der Grenzfläche zwischen beeinflusstem und unbeeinflusstem Substratmaterial und damit den Verlauf der geplanten bzw. ausgezeichneten Oberfläche (teilweise) zu bestimmen bzw. zu beeinflussen.

Es ist damit bevorzugt möglich, dass das zum Strukturieren der ausgezeichneten Oberfläche zu entfernende Material in einer anderen Form als in Pulverform von dem ursprünglichen Substratkörper entfernt wird. Dieses Verfahren ist dann auch in Räumen mit hohen Reinheitsanforderungen, wie Reinräumen, anwendbar. Ein Pulver liegt beispielsweise bei einer Teilchengröße von weniger als 10 nm vor.

In einer Ausführungsform wird zum Strukturieren der ausgezeichneten Oberfläche von dem ursprünglichen Substratkörper Material entfernt.

In einer Ausführungsform wird das zum Strukturieren der ausgezeichneten Oberfläche von dem ursprünglichen Substratkörper entfernte Material als ganz oder zumindest teilweise zusammenhängendes Materialstück(e) von dem ursprünglichen Substratkörper entfernt.

Dabei können ausgezeichnete Oberflächen unterschiedlicher Art strukturiert werden. Dies ermöglicht es, Substratkörper für verschiedene Anwendungszwecke bereitstellen zu können.

Beispielsweise kann eine nichtlineare Wechselwirkung in nur einem einzigen gekrümmten Wirkbereich hervorgerufen werden. Dann wird nur dort das Substratmaterial beeinflusst. Beispielsweise kann das beeinflusste Substratmaterial dann komplett innerhalb des Substratmaterials eingeschlossen sein und nicht an eine Oberfläche des Substratkörpers treten. Oder das beeinflusste Substratmaterial kann an eine Oberfläche oder an mehrere, insbesondere zwei gegenüberliegende, Oberflächen des Substratkörpers treten. Dann erstreckt sich das beeinflusste Substratmaterial von einer Oberfläche zu der wenigstens einen anderen Oberfläche.

Beispielsweise kann eine nichtlineare Wechselwirkung auch in mehreren gekrümmten Wirkbereichen hervorgerufen werden und dort jeweils das Substratmaterial beeinflusst werden. Die einzelnen gekrümmten Wirkbereiche können dann beispielsweise aufeinanderfolgen. Die gekrümmten Wirkbereiche können dann auch jeweils relativ zueinander versetzt und/oder um eine Hauptachse des jeweiligen Wirkbereichs gedreht sein.

Wenn das Substratmaterial in einem gekrümmten Wirkbereich beeinflusst wird, wird durch die Gestalt des gekrümmten Wirkbereichs der erste Verlauf der ausgezeichneten Oberfläche (teilweise) bestimmt bzw. beeinflusst. Dies ist klar, denn anschaulich gesprochen wird das Substratmaterial in einem gekrümmten Volumenbereich beeinflusst. Der gekrümmte Volumenbereich weist eine Oberfläche auf, die gleichzeitig auch eine Grenzfläche zu dem unbeeinflussten Substratmaterial darstellt. Der Oberflächenbereich des unbeeinflussten Substratmaterials und der des Volumenbereichs sind gerade komplementär (negativ) zueinander. Damit kann die Gestalt des gekrümmten Wirkbereichs einen Oberflächenbereich des unbeeinflussten Substratmaterials mitbestimmen bzw. beeinflussen. Dadurch wird die ausgezeichnete Oberfläche durch die gekrümmte Gestalt des Wirkbereichs (teilweise) bestimmt bzw. beeinflusst.

Das Verfahren kann optional mit weiteren Maßnahmen betrieben werden und damit in der Gesamtschau keine oder nur wenige Mikrorisse im Bereich der ausgezeichneten Oberfläche erzeugen. Dadurch ist die Festigkeit der ausgezeichneten Oberfläche von Beginn an hoch und der strukturierte Substratkörper somit außerordentlich widerstandsfähig.

Das Verfahren kommt ohne die Anwendung von mechanischer Spannung beim Abtrennen von Teilen des Substratmaterials aus. Damit kann beispielsweise ein Substratkörper ohne mechanische Spannung in zwei Teile getrennt oder eine Ausnehmung aus ihm entfernt werden. Damit wird der Substratkörper nicht beansprucht und nicht oder nicht sonderlich geschädigt.

Damit ermöglicht es das vorgeschlagene Verfahren, ein Ausgangssubstrat zu bearbeiten, so dass eine vorgegebene oder vorgebbare Oberfläche, wie etwa eine Trennfläche, als ausgezeichnete Oberfläche ausgebildet wird.

Die vorliegende Erfindung stellt damit einen Substratkörper bereit, dessen Oberfläche, insbesondere dessen umlaufende Seitenflächen, zumindest bereichsweise eine vorgegebene Sollfläche besitzt und dessen Oberflächen vorzugsweise insgesamt geätzt sein können. Ein spannungsbehafteter Trennprozess muss dabei nicht angewendet werden.

Dadurch lässt sich die ausgezeichnete Oberfläche sehr präzise ausbilden.

Insbesondere müssen mit dem vorgeschlagenen Verfahren keine Polierprozesse an der strukturierten Oberfläche angewendet werden. Gerade wenn die strukturierte Oberfläche ganz oder teilweise eine Seitenfläche des Substratkörpers darstellt, ist ein Poliervorgang, insbesondere bei dünnen Substratkörpern, nicht oder nur unter erschwerten Bedingungen durchführbar.

Denn Polierprozesse einer Substratoberfläche erfordern, gerade bei Seitenflächen, eine hohe Formstabilität des Substrates und damit entsprechend ausreichende Dicken, um ein mechanisches Aufspannen des Substratkörpers in der Poliermaschine bewerkstelligen zu können. Das vorliegende Verfahren kommt ohne Polierprozesse aus, weshalb auch sehr dünne Substratkörper strukturiert werden können.

In einer Ausführungsform liegt eine nichtlineare Wechselwirkung zwischen dem elektromagnetischen Feld und dem Substratmaterial vor, wenn sich zumindest im Bereich des gekrümmten Wirkbereichs aufgrund des elektromagnetischen Felds eine nichtlineare Absorption des Substratmaterials einstellt.

Beispielsweise kann die nichtlineare Wechselwirkung zwischen dem elektromagnetischen Feld und dem Substratmaterial eine nichtlineare Absorption des Substratmaterials aufweisen.

In einer Ausführungsform ist der Substratkörper aus Glas, Glaskeramik, Silizium oder Saphir oder weist dieses auf.

In einer Ausführungsform kann ein mechanisches Trennen unter feuchter Atmosphäre und/oder mit $CO_2$-Cleaven durchgeführt werden. Dies kann vorteilhaft dazu ausgenutzt werden, dass ein Substratkörper gleich nach der Wechselwirkung mit dem elektromagnetischen Feld mit gebogener bzw. gekrümmter Kante vorliegt.

Das elektromagnetische Feld ist innerhalb der gekrümmten Wirkbereiche derart eingestellt, dass dort, insbesondere innerhalb des gesamten gekrümmten Wirkbereichs, eine nichtlineare Wechselwirkung zwischen dem elektromagnetischen Feld und dem Substratmaterial hervorgerufen wird.

In einer Ausführungsform wird das Substratmaterial in dem wenigstens einen gekrümmten Wirkbereich einem solchen elektromagnetischen Feld ausgesetzt, dass in dem gekrümmten Wirkbereich eine nichtlineare Wechselwirkung zwischen dem elektromagnetischen Feld und dem Substratmaterial hervorgerufen wird und so das in dem gekrümmten Wirkbereich angeordnete Substratmaterial zumindest teilweise beeinflusst wird.

In einer Ausführungsform umfasst die nichtlineare Absorption des elektromagnetischen Feldes im Substratmaterial, dass eine nichtlineare Absorption eines Laserstrahls im Substratmaterial verursacht wird.

Alternativ oder ergänzend kann auch vorgesehen sein, dass das Substratmaterial in mehreren gekrümmten Wirkbereichen einem elektromagnetischen Feld ausgesetzt wird, wobei vorzugsweise

(i) die ausgezeichnete Oberfläche an mehreren Bereichen den gleichen ersten gekrümmten Verlauf aufweist, insbesondere bestimmt bzw. beeinflusst durch die gekrümmte Gestalt der mehreren gekrümmten Wirkbereiche, und/oder überall den ersten gekrümmten Verlauf aufweist, und/oder

(ii) die gekrümmten Wirkbereiche beabstandet zueinander angeordnet gewählt werden, insbesondere in einer Querschnittsebene des Substratkörpers die Mittelpunkte oder Schwerpunkte der Schnittflächen der gekrümmten Wirkbereiche mit der Querschnittsebene entlang einer geraden Linie oder entlang einer beliebigen, insbesondere kreisförmigen, Kurve verlaufen und/oder aufeinanderfolgende Wirkbereiche einen Abstand zueinander aufweisen, der zwischen 30 % und 100 % oder zwischen 100 % und 200 % der maximalen Ausdehnung der gekrümmten Wirkbereiche in der Querschnittsebene beträgt.

Wenn mehrere gekrümmte Wirkbereiche eingesetzt werden, kann besonders einfach eine ausgedehnte ausgezeichnete Oberfläche bereitgestellt werden. Beispielsweise lässt sich eine ausgedehnte Seitenfläche des Substratkörpers damit zuverlässig strukturieren. Die einzelnen gekrümmten Wirkbereiche können dann beispielsweise aufeinanderfolgen. Die gekrümmten Wirkbereiche können auch jeweils relativ zueinander versetzt und/oder um eine Hauptachse des jeweiligen Wirkbereichs gedreht sind. Dadurch können mehrere aufeinanderfolgende Bereiche mit beeinflusstem Substratmaterial erzeugt werden, und durch Freilegen und/oder Weiterverarbeitung der jeweiligen Grenzfläche zwischen beeinflussten und unbeeinflussten Substratmaterial die ausgezeichnete Oberfläche ausgebildet werden.

In einer Ausführungsform wird das Substratmaterial in wenigstens zwei gekrümmten Wirkbereichen einem elektromagnetischen Feld ausgesetzt. Vorzugsweise wird die ausgezeichnete Oberfläche durch beide gekrümmte Wirkbereiche bestimmt bzw. beeinflusst, insbesondere an unterschiedlichen Orten. Damit ist es in einer Ausführungsform möglich, dass der erste gekrümmte Verlauf durch die mehreren gekrümmten Wirkbereiche an mehreren Bereichen der ausgezeichneten Oberfläche erreicht wird.

Der erste gekrümmte Verlauf kann dabei auch nur von einem Teil des gekrümmten Wirkbereichs, insbesondere von einem Teil von dessen äußerer Oberfläche, bestimmt bzw. beeinflusst werden. Zu welchem Grade ein gekrümmter Wirkbereich den ersten gekrümmten Verlauf mitbestimmt kann damit zusammenhängen, wie dicht die einzelnen Wirkbereiche aufeinanderfolgen und wie das beeinflusste Substratmaterial weiterverarbeitet wird.

In einer Querschnittsebene des Substratkörpers können dann die einzelnen gekrümmten Wirkbereiche entlang einer geraden Linie oder entlang einer beliebigen Kurve, insbesondere eines Kreisbogens oder eines kompletten Kreises, angeordnet verlaufen. Beispielsweise können bestimmte Abstände zwischen den Mittelpunkten oder Schwerpunkten der in der Querschnittsebene liegenden aufeinanderfolgenden Schnittflächen der gekrümmten Wirkbereiche bestehen. Die Abstände können etwa zwischen 100 % und 200 %, vorzugsweise zwischen 110 % und 150 % oder zwischen 140 % und 180 %, der maximalen Ausdehnung der gekrümmten Wirkbereiche in der Querschnittsebene betragen. In diesem Fall verlaufen die gekrümmten Wirkbereiche durch so genannte Stegbereiche beabstandet zueinander. Die Abstände können auch zwischen 30 % und 100 %, vorzugsweise zwischen 50 % und 70 % oder zwischen 60 % und 80 %, der maximalen Ausdehnung der gekrümmten Wirkbereiche in der Querschnittsebene betragen. In diesem Fall sind die gekrümmten Wirkbereiche sozusagen ineinandergesetzt, oder mit anderen Worten ausgedrückt, die Stegbereiche weisen eine negative Breite auf.

Beispielsweise kann eine bestehende, beispielsweise plane oder anders geformte, Seitenfläche des Substratkörpers neu strukturiert werden. Dazu kann das Substratmaterial in aufeinanderfolgenden gekrümmten Wirkbereichen entlang der bestehenden Seitenfläche beeinflusst werden. Soweit dann noch nicht erfolgt, kann durch ggf. weitere Maßnahmen das beeinflusste Material entfernt und die ausgezeichnete Oberfläche vollends ausgebildet werden.

Wenn, wie hier, mehrere (gleiche) gekrümmte Wirkbereiche zur Strukturierung der Oberfläche eingesetzt werden, wird die ausgezeichnete Oberfläche an mehreren Bereichen gleichermaßen durch die gekrümmten Wirkbereiche bestimmt bzw. beeinflusst. Daher weist auch die ausgezeichnete Oberfläche überall dort den gleichen ersten gekrümmten Verlauf auf.

In einer Ausführungsform kann der erste gekrümmte Verlauf mehrfach oder durchgehend an der ausgezeichneten Oberfläche festgestellt werden. Beispielsweise können für die Strukturierung der ausgezeichneten Oberfläche mehrere gekrümmte Wirkbereiche verwendet werden, die zueinander nicht-überlappend beabstandet gewesen sind. Dann kann vorzugsweise an der ausgezeichneten Oberfläche der erste gekrümmte Verlauf überall dort, wo ein gekrümmter Wirkbereich gewirkt hat, festgestellt werden.

Beispielsweise können für die Strukturierung der ausgezeichneten Oberfläche auch mehrere gekrümmte Wirkbereiche verwendet werden, die zueinander überlappend beabstandet gewesen sind. Insbesondere kann die Überlappung sehr stark gewählt werden, also beispielsweise zwischen 0,1 % und 80 %, vorzugsweise zwischen 0,1 % und 20 %, vorzugsweise zwischen 0,1 % und 5 %, vorzugsweise zwischen 0,1 % und 1 %, der maximalen Ausdehnung des gekrümmten Wirkbereichs in einer Ebene senkrecht zur Haupterstreckungsrichtung des gekrümmten Wirkbereichs. Dann kann vorzugsweise an der ausgezeichneten Oberfläche der erste gekrümmte Verlauf durchgehend festgestellt werden. Denn mit zunehmender Überlappung bestimmt an jeder Stelle der ausgezeichneten Oberfläche zunehmend nur noch der am weitest außen verlaufende Teil des gekrümmten Wirkbereichs die Form der ausgezeichneten Oberfläche.

In einer Ausführungsform verläuft der erste gekrümmte Verlauf senkrecht zum Verlauf der zueinander beabstandeten gekrümmten Wirkbereiche.

Beispielsweise kann eine, insbesondere rechteckige oder runde, Ausnehmung aus dem, beispielsweise quaderförmigen, Substratkörper herausgeschnitten werden. Anschließend liegen dann zwei Teile vor, einmal der Substratkörper mit Ausnehmung und einmal das ausgeschnittene Teil. Dazu kann das Substratmaterial in aufeinanderfolgenden gekrümmten Wirkbereichen entlang einer (in einer Querschnittsebene des Substratkörpers definierbaren) Kurve, beispielsweise einer rechteckigen oder kreisförmigen Kurve, beeinflusst werden. Soweit dann noch nicht erfolgt, kann durch ggf. weitere Maßnahmen das beeinflusste Material entfernt werden. Indem das beeinflusste Material, wann auch immer, entfernt wird, kann die ausgezeichnete Oberfläche vollends ausgebildet und, da keine Verbindung mehr zu zwischen dem Substratkörper und dem ausgeschnittenen Teil besteht, dieses von dem Substratkörper gelöst werden.

Gemäß einer Definition kann das Teil, aus dem eine Ausnehmung herausgeschnitten wurde, der strukturierte Substratkörper sein. Gemäß einer anderen Definition kann das Teil, das aus dem zu strukturierenden Substratkörper herausgeschnitten wurde, der strukturierte Substratkörper sein.

Ganz analog kann ein Substratkörper entlang einer geplanten Oberfläche getrennt werden, und damit die ausgezeichnete Oberfläche ausgebildet werden, indem das Substratmaterial in aufeinanderfolgenden gekrümmten Wirkbereichen entlang einer (in einer Querschnittsebene des Substratkörpers definierbaren) geraden oder beliebig geformten Kurve beeinflusst wird. Das ermöglicht darüber hinaus die Möglichkeit, den Verlauf der Trennfläche entlang ihrer Haupterstreckungsrichtung sehr flexibel kontrollieren und einstellen zu können.

Es muss dabei nicht die gesamte ausgezeichnete Oberfläche durch die Gestalt eines oder mehrerer gekrümmter Wirkbereiche bestimmt oder beeinflusst sein. Beispielsweise kann das innerhalb zweier benachbarter gekrümmter Wirkbereiche beeinflusste Substratmaterial letztlich entfernt worden sein und so zwei Hohlräume in den Substratkörper eingebracht werden. Die durch Verbinden der beiden Hohlräume, also indem das Wand-Material zwischen diesen entfernt wird, freigelegte Oberfläche kann auch Teil der ausgezeichneten Oberfläche sein.

Alternativ oder ergänzend kann auch vorgesehen sein, dass das Beeinflussen des Substratmaterials aufweist, eine oder mehrere Materialeigenschaften, wie insbesondere den Brechungsindex, die Ätzrate und/oder die Dichte, des Substratmaterials zumindest bereichsweise zu verändern, insbesondere zu erhöhen oder zu verringern, und/oder

dass das Beeinflussen des Substratmaterials aufweist, das Substratmaterial zumindest teilweise aus dem gekrümmten Wirkbereich zu entfernen und/oder zu verdrängen, insbesondere das Substratmaterial in das umgebene Substratmaterial hineinzuverdichten.

Indem das Substratmaterial beim Beeinflussen in seinen Materialeigenschaften verändert wird, lässt sich gezielt das Substratmaterial auswählen, das beispielsweise mit weiteren Maßnahmen entfernt werden soll, um die ausgezeichnete Oberfläche, oder Teile davon, auszubilden. Außerdem können die Materialeigenschaften vorzugsweise dazu eingesetzt werden, dass je nach Grad der Beeinflussung das beeinflusste Material mit weiteren Maßnahmen unterschiedlich schnell durch das Anwenden einer Maßnahme entfernt werden kann. Dadurch kann die Selektivität, mit der das beeinflusste Material auf die weiteren Maßnahmen reagiert, sogar räumlich eingestellt werden.

In jedem Fall lässt sich die ausgezeichnete Oberfläche durch die unterschiedlichen Eigenschaften des Materials gut identifizieren und kann dann durch geeignete Maßnahmen freigelegt werden. Dabei sind gerade solche Maßnahmen bevorzugt, die auf die Bereiche mit unterschiedlichen Materialeigenschaften unterschiedlich wirken. Wenn also eine Maßnahme nur auf das beeinflusste Substratmaterial wirkt, kann dieses nach der Beeinflussung gezielt bearbeitet, wie etwa entfernt, werden. Wenn das beeinflusste Substratmaterial entfernt ist, weist der Substratkörper dort eine neue Oberfläche als zumindest ein Teil der ausgezeichneten Oberfläche auf. Diese neue Oberfläche ist durch die gekrümmte Gestalt des oder der Wirkbereiche bestimmt bzw. beeinflusst.

Indem das Substratmaterial beim Beeinflussen unmittelbar entfernt bzw. verdrängt wird, kann das Strukturieren der ausgezeichneten Oberfläche sehr effizient durchgeführt werden. Weitere Maßnahmen sind dann unter Umständen nicht mehr notwendig. Dann ist die nach dem Beeinflussen geschaffene neue Oberfläche gleich die ausgezeichnete Oberfläche oder ein Teil davon. Natürlich ist es aber auch denkbar, dass dennoch weitere Maßnahmen ergriffen werden, so dass die neue Oberfläche nach dem Beeinflussen erst nach der Anwendung von weiteren Maßnahmen die ausgezeichnete Oberfläche oder Teile davon darstellt.

Indem das entfernte Material in den Substratkörper hineinverdichtet wird, kann eine erhöhte Festigkeit der ausgezeichneten Oberfläche erreicht werden. Dies kann damit erklärt werden, dass das Hineinverdichten das Substratmaterial im Bereich der zu strukturierenden Oberfläche dichter und damit widerstandsfähiger wird.

Alternativ oder ergänzend kann auch vorgesehen sein, dass die ausgezeichnete Oberfläche ausgebildet wird, indem durch das Beeinflussen das Substratmaterial zumindest teilweise entfernt wird und/oder indem wenigstens das beeinflusste Substratmaterial durch zumindest einen nachfolgenden Ätzvorgang, insbesondere nasschemisch, mittels einer Säure und/oder mittels einer Lauge, zumindest teilweise entfernt wird, wobei vorzugsweise als Ätzmedium eine Kalilauge eingesetzt wird.

Das beeinflusste Substratmaterial kann durch einen Ätzvorgang, der vorzugsweise nach dem Beeinflussen durchgeführt wird, entfernt werden. Damit ist ein besonders effizientes und zielgerichtetes Bereitstellen der ausgezeichneten Oberfläche möglich. So kann eine Ätztechnik und/oder ein Ätzmittel gewählt werden, womit zielgerichtet das beeinflusste Substratmaterial entfernt werden kann. Beispielsweise kann das beeinflusste Substratmaterial ganz oder teilweise weggeätzt werden. Das nicht beeinflusste Substratmaterial hingegen bleibt bestehen. Alternativ kann auch bereichsweise ein Teil des nicht beeinflussten Substratmaterials ebenfalls weggeätzt werden.

In einer Ausführungsform weist der Ätzvorgang ein isotropisches Ätzen des Substratkörpers, insbesondere des beeinflussten und/oder unbeeinflussten Substratmaterials, auf.

In einer Ausführungsform weist der Ätzvorgang Naß- und/oder Trockenätzen des Substratkörpers, insbesondere des beeinflussten und/oder unbeeinflussten Substratmaterials, auf.

Ein Ätzvorgang in Kombination mit dem Einsatz von mehreren gekrümmten Wirkbereichen und damit Beeinflussungen des Substratmaterials ist dabei besonders wirkungsvoll. So kann das Substratmaterial in mehreren gekrümmten Wirkbereiche beeinflusst werden. Dabei können die einzelnen gekrümmten Wirkbereiche getrennt voneinander sein, also zunächst nicht miteinander verbunden sein. Beispielsweise können die einzelnen Wirkbereiche in eine Richtung parallel zueinander beabstandet angeordnet sein. Durch einen Ätzvorgang können dann die Bereiche mit beeinflusstem Substratmaterial entfernt werden. Durch fortgesetztes Ätzen kann auch das Substratmaterial im Bereich zwischen zwei Wirkbereichen, also das unbeeinflusste Substratmaterial, von dem Ätzvorgang ebenfalls entfernt werden. Dadurch kann eine Verbindung zwischen den einzelnen (freigeätzten) Wirkbereichen hergestellt werden.

Wenn die mehreren Wirkbereiche und damit die Beeinflussungen von einer Seite zu einer anderen Seite verlaufen, führt dies beispielsweise gleichzeitig zu einer Trennung des Substratkörpers in zwei Teile.

Wenn die mehreren Wirkbereiche und damit die Beeinflussungen von einer Seite zu einer anderen Seite verlaufen, führt dies beispielsweise lediglich zur Ausbildung einer äußeren Oberfläche des Substratkörpers, wenn die Wirkbereiche nahe an der vormaligen Substratrandfläche verlaufen oder sogar mit dieser abschließen.

Da also wenigstens das beeinflusste Substratmaterial durch den Ätzvorgang entfernt wird, ist es auch möglich, dass unbeeinflusstes Substratmaterial durch den Ätzvorgang entfernt wird.

Durchstößt die Beeinflussung wenigstens eine Substratoberfläche des Substratkörpers (das heißt, reicht eine Beeinflussung bis zu wenigstens einer Substratoberfläche), so kann beispielsweise mittels dem so genannten laserselektiven Ätzen das beeinflusste Substratmaterial aus dem Substratkörper herausgeätzt werden (so genanntes nicht isotropes Ätzen). Hierbei wird ausgenutzt, dass die beeinflussten Bereiche des Substratmaterials während des Ätzens, wie insbesondere dem nasschemischen Ätzen, schneller aus dem Substratmaterial herausgeätzt werden, als nicht beeinflusste Bereiche. Im Fall der einseitigen Durchstoßung wird neben dem gleichmäßigen Abtragen von Substratmaterial von allen Substratseiten wird im Bereich des beeinflussten Substratmaterials eine Kavität (d.h. eine einseitige Öffnung) erzeugt, weil der lasermodifizierte Bereich schneller geätzt wird als das umgebende Substratmaterial. Durchstößt der beeinflusste Bereich gar zwei, insbesondere sich gegenüberliegende, Oberflächen, so kann auf diese Weise auch ein gekrümmtes Durchgangsloch ("Via") erzeugt werden. Vorzugsweise kann ein solches gekrümmtes Durchgangsloch durch einen nachfolgenden Metallisierungsprozess als Basis zur Herstellung eines Interposers verwendet werden.

In einer Ausführungsform durchstößt der gekrümmte Wirkbereich mindestens eine der Oberflächen des Substratkörpers, wie erste und/oder zweite Deckfläche.

In bevorzugten Ausführungsformen weist der nachfolgende Ätzvorgang daher laseraktives Ätzen wenigstens des beeinflussten Substratmaterials auf.

Als Ätzmedium für das laserselektive Ätzen kann beispielsweise Flusssäure (HF), Natriumhydroxid (NaOH) und/oder eine Kalilauge (KOH) verwendet werden.

Vorzugsweise wird der Ätzprozess in einem sauren und/oder alkalischen Ätzmedium durchgeführt.

Vorzugsweise wird der Ätzprozess bis zum Verbinden der Bereiche, aus denen beeinflusstes Substratmaterial entfernt wurde, durchgeführt.

Vorzugsweise wird der Ätzprozess bis zum Verbinden der beeinflussten Bereiche durchgeführt.

Mit zunehmender mittlerer Prozessleistung und damit Pulsenergie des elektromagnetischen Feldes (beispielsweise eines eingesetzten Lasers) besteht die (beispielsweise vom Laser bzw. dessen Linienfokus) erzeugte Beeinflussung ganz oder teilweise nicht mehr in der Änderung von Dichte und Brechungsindex des Substratmaterials, sondern auch beispielsweise in einem in das Substratmaterial eingebrachten, vorzugsweise ein- oder mehrseitig nach außen tretenden, Hohlraum. Ein nach außen tretender Hohlraum bedeutet hierbei, dass der Hohlraum von außen zugänglich ist. Wenn er einseitig nach außen tritt, ist er von einer Öffnung her zugänglich. Wenn er zweiseitig nach außen tritt, ist er von zwei Öffnungen her zugänglich.

Bei Vorliegen eines solchen nach außen tretenden Hohlraums als Folge des Beeinflussens, kann das Ätzmedium dort eindringen und in einem isotropen Ätzprozess gleichzeitig Substratmaterial von allen Oberflächen des Substratkörpers, insbesondere auch von der Oberfläche des erzeugten Hohlraums, entfernen und damit den Durchmesser des Hohlraums vergrößern. Beispielsweise wird hierzu ein Kalilaugen (KOH)-basierter Ätzprozess angewandt. Eine Besonderheit der basisch geätzten Substratoberfläche, wie beispielsweise einer Glasoberfläche, ist, dass die Oberfläche in Form kalottenförmiger Vertiefungen ausgebildet wird.

Ein Hohlraum kann beispielsweise in Form eines gekrümmten Lochs in dem Substratmaterial eingebracht sein, das dann beispielsweise an zwei gegenüberliegenden Seiten nach außen tritt. Vorzugsweise wird mittels eines Ätzvorgangs das gekrümmte Loch aufgeweitet. Dabei kann dies der gleiche Ätzvorgang sein, mit dem zuvor das beeinflusste Material entfernt wurde und im Rahmen des fortgesetzten Ätzvorgangs dann nahtlos auch das unbeeinflusste Material entfernt wird. Vorzugsweise wird der Ätzvorgang dann solange durchgeführt, bis benachbarte Hohlräume miteinander verbunden sind.

In einer Ausführungsform wird das beeinflusste Substratmaterial zumindest bereichsweise und/oder zeitweise nicht isotrop geätzt.

In einer Ausführungsform wird das beeinflusste Substratmaterial zumindest bereichsweise und/oder zeitweise isotrop geätzt.

In einer Ausführungsform wird das Substratmaterial beeinflusst und anschließend zumindest das beeinflusste Substratmaterial nicht isotrop weggeätzt, um dadurch Hohlräume, insbesondere Durchgangsöffnungen, im Substratkörper auszubilden. Optional kann durch weiteres Ätzen auch nicht beeinflusstes Substratmaterial zwischen den Durchgangsöffnungen zumindest bereichsweise weggeätzt werden, um dadurch die Durchgangsöffnungen zumindest bereichsweise miteinander zu verbinden. Diese Verbindungsflächen können dann ebenfalls Teil der ausgezeichneten Oberfläche sein.

Es lässt sich dabei besonders bevorzugt erreichen, dass die ausgezeichnete Oberfläche zumindest bereichsweise in der Höhe moduliert ist. Beispielsweise kann sie zumindest bereichsweise kalottenförmig ausgestaltet sein. Dies kommt dadurch zustande, dass die ausgezeichnete Oberfläche sowohl durch das Entfernen (beispielsweise Wegätzen) von beeinflusstem Substratmaterial als auch durch das Entfernen (beispielsweise Wegätzen) von unbeeinflusstem Substratmaterial freigelegt wird.

Diese Höhenmodulation hat sich als vorteilhaft erwiesen, da sie zu einer erhöhten Festigkeit der ausgezeichneten Oberfläche beiträgt. Es ist daher in Ausführungsformen bevorzugt, dass die ausgezeichnete Oberfläche zumindest bereichsweise eine kalottenförmige Struktur, wie kalottenförmige Vertiefungen, aufweist.

Bei Bestehen mehrerer aufeinanderfolgender Bereiche mit beeinflusstem Substratmaterial wird in einer Ausführungsform der Ätzprozess solange durchgeführt, bis die beeinflussten Bereiche nicht nur geöffnet sind (d.h. das beeinflusste Material dort weggeätzt wurde), sondern auch verbunden wurden. Dann können die beiden Substratteile, beispielsweise als Innen- und Aussenteil, kraftfrei und als Ganzes voneinander getrennt werden.

Alternativ oder ergänzend kann auch vorgesehen sein, dass das elektromagnetische Feld in Form eines und/oder durch einen gekrümmten Linienfokus, insbesondere eines Laserstrahls, bereitgestellt wird und/oder der gekrümmte Wirkbereich durch die Form des Linienfokus bestimmt wird.

Es ist eine besonders effiziente Möglichkeit, das elektromagnetische Feld in Form eines gekrümmten Linienfokus bereitzustellen. Denn ein Linienfokus kann gerade mit einem Laser sehr einfach und in vielen unterschiedlichen Formen ausgebildet werden.

Ein Laserstrahl, dessen Linienfokus eingesetzt wird, kann mit bekannten Mitteln entlang eines optischen Pfades gelenkt und kontrolliert werden. Der Linienfokus kann mit unterschiedlichen Mitteln, wie optische Elemente, eingestellt und angepasst werden. Damit kann ein elektromagnetisches Feld innerhalb des Substratkörpers erzeugt werden, das jede räumliche Gestalt annehmen kann, die mit Mitteln der Strahlformung und Strahlbeeinflussung erzielbar ist.

Dementsprechend kann auch in entsprechend geformten Bereichen des Substratkörpers eine nichtlineare Wechselwirkung mit dem Substratmaterial erzeugt werden.

Ein Laserstrahl mit Linienfokus stellt damit ein äußerst flexibles Mittel dar, in den gekrümmten Wirkbereichen eine nichtlineare Wechselwirkung zwischen dem elektromagnetischen Feld und dem Substratkörper zu erreichen, insbesondere um eine nichtlineare Absorption zu erreichen.

Bei der Bearbeitung von Substratkörpern mittels Laser ist generell zwischen Prozessen linearer und nichtlinearer Absorption zu unterscheiden. Lineare Absorption liegt vor, wenn das zu bearbeitende Material für die Wellenlänge des verwendeten Lasers teil- oder komplettabsorbierend ist (Bsp.: Absorption von $CO_2$-Laserstrahlung in Glas), so dass entsprechend über Laserwellenlänge, -energie, Pulsdauer und dergleichen die Stärke der Wechselwirkung eingestellt werden kann. Hiervon zu unterscheiden sind die Prozesse der nichtlinearen Absorption, bei der das zu bearbeitende Material im Bereich der verwendeten Laserstrahlung zunächst keine Absorption aufweist, also transparent für die Laserwellenlänge(n) ist. Durch Erzeugen sogenannter ultrakurzer Laserpulse (typische Pulslängen bewegen sich hierbei im Bereich 10 ps bis 100 fs, insbesondere im Bereich 1 ps bis 100 fs) werden aber im Substratmaterial durch den Laser ausreichend hohe elektromagnetische Felder erzeugt, die eine nichtlineare Änderung von Materialeigenschaften des Substratkörpers bzw. dessen Material, wie der Brechungsindex, und damit der Absorptionseigenschaften des Materials hervorrufen. Werden das Material kennzeichnende Schwellwerte überschritten, so erzeugt der Laserstrahl eine bleibende Beeinflussung im Material. Die hierdurch erzeugten lokalen Änderungen des Materials erstrecken sich von permanenten Änderungen des Brechungsindex, Änderung des Ätzverhaltens (selektives Laseretching) bis hin zum Erzeugen von Rissen und Kanälen im Substrat, jeweils abhängig von dem Zusammenspiel der Laser- und Materialparameter und begrenzt auf den Bereich des gebildeten Laserfokus im Material.

Beispielsweise liegt die kritische Intensität für ein Glassubstrat, um darin eine nichtlineare Änderung von Materialeigenschaften hervorzurufen, bei wenigstens $10^{13}$ W/cm$^2$.

In einer Ausführungsform weist das Substratmaterial Glas auf und das elektromagnetische Feld weist eine Feldstärke von wenigstens $10^{13}$ W/cm$^2$, vorzugsweise von wenigstens $5\times10^{13}$ W/cm$^2$, vorzugsweise von wenigstens $10^{14}$ W/cm$^2$, am bevorzugtesten von wenigstens $5\times10^{14}$ W/cm$^2$ auf. Optional weist das elektromagnetische Feld eine Feldstärke von maximal $10^{16}$ W/cm$^2$ auf.

In einer Ausführungsform entspricht der gekrümmte Wirkbereich dem Bereich, in dem der Linienfokus eines Lasers eine nichtlineare Wechselwirkung mit dem Substratmaterial hervorruft, wobei die nichtlineare Wechselwirkung vorzugsweise eine nichtlineare Absorption aufweist und/oder darstellt, und das Substratmaterial dadurch beeinflusst.

Aufgrund der Anwesenheit des Linienfokus besteht in dem betreffenden gekrümmten Wirkbereich auch ein elektromagnetisches Feld, das die nichtlineare Wechselwirkung hervorruft.

In einer Ausführungsform findet innerhalb des gesamten gekrümmten Wirkbereichs eine nichtlineare Wechselwirkung zwischen dem elektromagnetischen Feld und dem Substratmaterial statt.

In einer Ausführungsform entspricht das elektromagnetische Feld dem Linienfokus.

Alternativ oder ergänzend kann auch vorgesehen sein, dass der Laserstrahl durch einen Ultrakurzpulslaser bereitgestellt wird,

dass die Phase des Laserstrahls eingestellt und/oder angepasst wird, insbesondere mittels eines Spatial Light Modulators, eines diffraktives optischen Elements und/oder eine Kombination mehrerer Zylinderlinsen,

dass der Laserstrahl auf den Substratkörper fokussiert wird, vorzugsweise mittels eines Mikroskopobjektivs oder einer Fourierlinse, wobei das Fokussieren vorzugsweise nach dem Einstellen bzw. Anpassen der Phase des Laserstrahls erfolgt und/oder den Linienfokus ausbildet,

dass der Linienfokus der eines beschleunigten Laserstrahls, insbesondere eines Airy-Strahls, ist,

dass die Wellenlänge des Laserstrahls 1064 nm beträgt, das Mikroskopobjektiv bzw. die Fourierlinse eine Brennweite von 10-20 mm aufweist, der Koeffizient der kubischen Phase (Laser-Parameter Beta) einen Wert von zwischen $0{,}5 \times 10^3$/m und $5 \times 10^3$/m aufweist, der Durchmesser des Rohstrahls (Laser-Parameter $\omega_0$) einen Wert von zwischen 1 mm und 10 mm, vorzugsweise von zwischen 2,5 mm und 5 mm, aufweist, die Pulsdauer (Laser-Parameter $\tau$) einen Wert von 0,1-10 ps aufweist, die Pulsenergie (Laser-Parameter $E_p$) einen Wert von zwischen 1 und 1.500 $\mu$J, vorzugsweise von zwischen 30 und 500 $\mu$J, insbesondere 474 $\mu$J, aufweist, und/oder die Anzahl der Pulse im Burst (Laser-Parameter N) einen Wert von zwischen 1 und 200, vorzugsweise von zwischen 1 und 100, insbesondere von zwischen 1 und 8, aufweist,

dass die räumliche Ausdehnung der gekrümmten Wirkbereiche, vorzugsweise ihre Länge und/oder ein ihrer Durchmesser, durch Variation des mittleren Leistungsbereichs des Lasers und/oder durch Phasenänderung eingestellt und/oder zeitlich verändert wird, insbesondere für zumindest einige der mehreren gekrümmten Wirkbereiche unterschiedliche Ausdehnungen eingestellt werden,

und/oder

dass die räumliche Orientierung der gekrümmten Wirkbereiche durch Variation der Verkippung der optischen Achse des Laserstrahls gegenüber der Normalen der Substratoberfläche, insbesondere derjenigen Substratoberfläche, auf die der Laserstrahl auf den Substratkörper auftrifft, eingestellt und/oder zeitlich verändert wird, insbesondere für zumindest einige der mehreren gekrümmten Wirkbereiche unterschiedliche Orientierungen eingestellt werden.

Die Phase des Laserstrahls kann die räumliche Gestalt des elektromagnetischen Felds des Linienfokus beeinflussen und damit den gekrümmten Wirkbereich einstellen und anpassen. Daher sind ein Spatial Light Modulator (SLM), ein diffraktives optisches Element und/oder eine Kombination mehrerer Zylinderlinsen, die allesamt die Phase des Laserstrahls anpassen können, geeignete Mittel, um die räumliche Gestalt des elektromagnetischen Felds zu kontrollieren.

Ein möglicher Aufbau zur erfindungsgemäßen Erzeugung eines gekrümmten Wirkbereichs und dazu eines entsprechend räumlich ausgebildeten elektromagnetischen Feldes kann im Prinzip wie folgt gestaltet werden: Der Laserstrahl eines Ultrakurzpulslasers trifft auf einen Spatial Light Modulator (SLM), der die Phase des einfallenden Laserpulses durch Aufprägen einer Phase, wie eine kubische Phase, ändert. Anschließend wird der Strahl durch ein Mikroskopobjektiv und/oder auf eine Fourierlinse auf den zu strukturierenden Substratkörper fokussiert. Abhängig von der sich einstellenden Phasenverteilung hinter dem Spatial Light Modulator erzeugt das abbildende Objektiv nun nicht mehr eine gerade, sondern eine gekrümmte Fokallinie, die im Substratkörper eine räumlich gekrümmte Beeinflussung des Substratmaterials hinterlässt. In einer Ausführungsform können auch die Nebenmaxima des Airy-Strahls unterdrückt werden. Dabei kann das Intensitäts-Verhältnis des Hauptfokus zum Rest des Strahls optimiert werden (1,2 -10). Das kann beispielsweise realisiert werden durch die nicht radialsymmetrischen Apodisierung in der Fourier-Ebene mittels einer Blende.

In einer bevorzugten Ausführungsform wird anstelle eines Spatial Light Modulators zur gezielten Änderung der Phasenverteilung ein diffraktives optisches Element (DOE) zur Erzeugung der gekrümmten Wirkbereiche verwendet. Beispielsweise hat dieses einen Durchmesser von 5-15 mm, vorzugsweise 9 mm, wobei der DOE in der "Front focal plane" des Mikroskopobjektivs bzw. der Fourierlinse liegt. Vorzugsweise hat der SLM oder der DOE (d.h. allgemein gesprochen der Phasenmaske) einen Arbeitsabstand von der betreffenden Linse, der gleich der Brennweite der Linse ist und/oder zwischen 2-15 mm, vorzugsweise 5 mm, beträgt. Wenn bei einem Mikroskopobjektiv die "front focal plane" im Objektiv selbst liegt, ist in diesen Fällen vorzugsweise der minimal (baulich bedingte) Abstand zu wählen. Bei einem SLM kann ein analoger Aufbau vorgesehen sein, beispielsweise ein 2f-Aufbau. Eine weitere Ausführungsform verwendet anstelle eines Spatial Light Modulators oder eines diffraktiven optischen Elements eine Kombination mehrerer Zylinderlinsen zur Erzeugung der Phase im Laserstrahl, wie insbesondere einer kubischen Phase.

Beispielsweise kann vorliegend ein Airy- -Strahl zum Einsatz kommen. Ein Airy-Strahl eignet sich besonders gut für eine asymmetrisch/seitlich Strahlzuführung.

Ein Airy-Strahl lässt sich außerdem besonders einfach und effizient erzeugen. Beispielsweise kann sich ein Airy-Strahl als Abbildung eines Strahls mit kubischer Phase, die entweder direkt durch eine Phasenmaske (DOE oder SLM) oder einen Aufbau mit Zylinderlinsen erzeugt wird, ergeben.

Durch geeignete Wahl des optischen Setups (insbesondere Festlegen des vertikalen Abstandes zwischen fokussierender Optik und zu dem zu bearbeitenden Substratmaterial, also der Fokuslage und -länge), können auf diese Art und Weise gekrümmte Wirkbereiche im Innern oder auch eine der beiden oder beide Großflächen (Grund- und/oder Deckfläche) durchstoßend im Substratmaterial hergestellt werden.

Vorzugsweise wird zur Erzeugung eines Linienfokus, insbesondere eines beschleunigten Strahls, ein SLM, ein DOE und/oder eine Linsenoptik entweder als einzelne Komponente oder als Arrangement von Linsen, wie Zylinderlinsen, zum Aufprägen einer geeigneten Phasenfunktion auf den Laserstrahl verwendet.

In einer Ausführungsform werden gekrümmte Wirkbereiche entlang einer geschlossenen Kontur in einem vorgegebenen Abstand zueinander (also mit einem sogenannten Pitch), beispielsweise mit einem Abstand von zwischen 1 μm und 50 μm, vorzugsweise zwischen 1 μm und 10 μm, zwischen 10 μm und 30 μm, zwischen 20 μm und 40 μm oder zwischen 30 μm und 50 μm, in dem Substratmaterial angeordnet. Es können Abstände von 1 μm, 20 μm oder 50 μm bevorzugt sein. Hierbei kann vorzugsweise durch Nachführen der Optik (mechanisches Nachführen des DOEs bzw. Änderung der Phasenverteilung per Software) die Ausrichtung der Modifikationen derart kontrolliert werden, dass eine konvexe ausgezeichnete Oberfläche ohne Verkippung der eingeschriebenen Strukturen oder mindestens unter einem konstanten Winkel entsteht. Derartig gekrümmte Wirkbereiche ermöglichen beispielsweise die Definition einer neuen Aussenkontur in einem Substratkörper, wie einem Rohglassubstrat. Optional kann dabei entlang der beabsichtigten Kontur das überschüssige Material - ggf. unter Verwendung von Hilfsschnitten - entfernt werden.

In einer Ausführungsform wird die Strahlausrichtung in konstantem Winkel relativ zur Sollkontur nachgeführt, vorzugsweise mechanisch beim DOE und per Software beim SLM.

In einer Ausführungsform wird die Strukturierungsreihenfolge von Oberflächen zur Verhinderung von unerwünschter Interaktion, wie insbesondere Verschattungen, kontrolliert. Eine vorteilhafte Interaktion zwischen aufeinanderfolgenden Beeinflussungen ist möglich, so dass eine Vorzugsrichtung entlang der Sollkontur eingestellt werden kann.

Ein Airy-Strahl bietet bevorzugte Eigenschaften für die Bereitstellung von elektromagnetischen Feldern.

Die nichtlineare Wechselwirkung lässt sich gezielt durch Wahl geeigneter Laser-Parameter in ihrer räumlichen Ausdehnung und/oder Stärke einstellen.

Generell ist bei der Strukturierung von Oberflächen, die nach außen oder innen zeigen (Innen- und/oder Außenoberflächen) bevorzugt, dass die Ausrichtung der Laseroptik die Ausbildung eines konvexen ersten gekrümmten Verlaufs nach innen (bei Strukturierung einer Innenoberfläche) bzw. nach außen (bei Strukturierung einer Außenoberfläche) ermöglicht. Auch ist die Kombination von Innen- und Außenoberflächen mit dem Verfahren möglich, insbesondere auch in einer einzigen Durchführung.

In Ausführungsformen ist die konkrete Form der gekrümmten Wirkbereiche oder des beeinflussten Substratmaterials durch die von SLM und/oder DOE aufgeprägte Phase bestimmt oder bestimmbar.

Es hat sich als besonders wirkungsvoll herausgestellt, dass durch den mittleren Leistungsbereich des Lasers die räumliche Ausdehnung des gekrümmten Wirkbereichs und damit der Beeinflussung des Substratmaterials eingestellt wird.

Durch Variation, insbesondere Erhöhung, der Pulsenergie des Laserpulses überschreitet die Laserleistung dann in einem größeren Bereich der gekrümmten Fokallinie einen Schwellwert des Substratmaterials. Somit kann die Länge des gekrümmten Wirkbereichs bzw. der Beeinflussung eingestellt werden.

Beispielsweise können unterschiedliche Längen der gekrümmten Wirkbereiche und damit der Beeinflussungen in einem Substratmaterial, wie etwa Glas, erreicht werden durch die Variation eines 10 ps-Laserpulses im mittleren Leistungsbereich des Lasers (beispielsweise mit einer Leistung von zwischen 1 W und 500 W, vorzugsweise von zwischen 1 W und 40 W, insbesondere von zwischen 2 W und 10 W, 10 W und 20 W, 20 W und 30 W oder 30 W und 40 W, und/oder Pulsenergien von zwischen 1 μJ und 500 μJ, vorzugsweise von zwischen 30 μJ und 300 μJ) und/oder durch Phasenänderungen mit dem Spatial Light Modulator.

Gekrümmte Wirkbereiche bzw. Beeinflussungen können, insbesondere mit den vorstehend genannten Mitteln, beispielsweise mit Längen von mehr als 0,1 mm bis hin zu mehr als 3 mm, vorzugsweise von zwischen 0,1 mm und 5 mm, insbesondere von zwischen 0,5 mm und 3 mm, und/oder einer maximalen Auslenkung von der geraden Fokallinie von 200 μm, vorzugsweise von zwischen 10 μm und 80 μm, insbesondere von zwischen 20 μm und 80 μm, erzeugt werden. Der Krümmungsverlauf der Beeinflussung, und damit letztlich auch der erste gekrümmte Verlauf der ausgezeichneten Oberfläche, wird durch den theoretisch durch die verwendete Phasenfunktion vorgebbare Form bestimmt bzw. beeinflusst.

In einer Ausführungsform wird daher der gekrümmte Wirkbereich durch eine Variation der Pulsenergie des Laserpulses in seiner Länge angepasst und/oder zeitlich verändert.

Die Ausdehnung des elektromagnetischen Felds und damit die räumliche Ausdehnung des gekrümmten Wirkbereichs kann besonders gezielt beeinflusst werden, wenn die mittlere Leistung des Pulses angepasst wird. Gleiches gilt auch für Phasenänderungen.

Beispielsweise führt eine höhere Leistung zu einer größeren Länge des gekrümmten Fokus. Daher kann die Leistung gezielt eingesetzt und/oder gesteuert werden, um den Fokus und damit den gekrümmten Wirkbereich in seiner räumlichen Ausdehnung anzupassen.

Beispielsweise führt eine stärkere kubische Phase zu einem längeren und stärker gekrümmten Fokus. Daher kann diese Phase gezielt eingesetzt und/oder gesteuert werden, um den Fokus und damit den gekrümmten Wirkbereich in seiner räumlichen Ausdehnung anzupassen.

Gerade wenn das Substratmaterial durch den Laser beeinflusst wird ohne dabei entfernt zu werden, ist in Ausführungsformen ein nachfolgender Ätzvorgang bevorzugt. Ätzabtrag und/oder -geschwindigkeit können dabei erhöht werden, indem die einzelnen Beeinflussungen in den gekrümmten Wirkbereichen nicht mit einzelnen Pulsen, sondern mit mehreren Pulsen innerhalb einer Pulsgruppe durchgeführt werden, also mittels eines so genannten Burstpulses. Es ist daher in Ausführungsformen bevorzugt, dass der Ultrakurzpulslaser mehrere Pulse innerhalb einer Pulsgruppe als Burstpuls durchführt.

Damit ermöglicht es das vorgeschlagene Verfahren, aus einem Ausgangs-Substrat, wie einem Glas- oder Glaskeramik-Substrat, ein Substrat vorgegebener (lateraler) Geometrie (Dicke) und einer vorgegebenen Oberfläche, insbesondere Seitenfläche, bereit zu stellen. Dazu kann das Substratmaterial des Ausgangssubstrates entlang der geplanten Oberfläche beispielsweise mittels eines Ultrakurzpuls (UKP)-Lasers innerhalb gekrümmter Wirkbereiche vorgegebener Form beeinflusst werden und anschließend die beeinflussten Bereiche des Substratmaterials selektiv geätzt und dadurch entfernt werden. Insbesondere kann solange geätzt werden, bis zum Verbinden der derartig definierten Bereiche, so dass anschließend die beiden Teile, zum Beispiel Innen- und Außenteil, kraftfrei voneinander getrennt werden können.

Alternativ oder ergänzend kann auch vorgesehen sein, dass zumindest während der nichtlinearen Wechselwirkung zumindest ein Hilfs-Substratkörper an dem Substratkörper angeordnet ist und sich der jeweilige gekrümmte Wirkbereich und/oder der Linienfokus zumindest teilweise in den Hilfs-Substratkörper hineinerstreckt, wobei vorzugsweise zwei oder mehr Hilfs-Substratkörper an dem Substratkörper angeordnet sind, insbesondere an gegenüberliegenden Seiten des Substratkörpers, und sich der jeweilige gekrümmte Wirkbereich und/oder der Linienfokus zumindest teilweise in zwei oder mehr Hilfs-Substratkörper hineinerstreckt.

Vorzugsweise ist der Hilfs-Substratkörpers aus dem gleichen Material wie der Substratkörper.

Mit einem solchen Hilfs-Substratkörper können Ablationsanteile oder -effekte auf den freien Substratoberflächen bei durchstoßenden gekrümmten Wirkbereichen vermieden oder zumindest erheblich reduziert werden.

Beispielsweise kann in einer Ausführungsform der zu strukturierende Substratkörper mit einem angesprengten, angebondeten und/oder ultrakurzpulsgeschweißten Hilfs-Substratkörper gemeinsam prozessiert werden, so dass während des Prozessierens zunächst nur innere Beeinflussungen erzeugt werden und diese in einem weiteren Prozessschritt (beispielsweise als Debonding beschreibbar) durch Entfernen des Hilfs-Substratkörper sozusagen freigelegt werden.

Durch das Vorsehen eines Hilfs-Substratkörpers kann damit auch im oberflächennahen Bereich des Substratkörpers eine besonders gezielte und den Vorgaben an die ausgezeichnete Oberfläche entsprechende Beeinflussung des Substratmaterials erfolgen. Denn aufgrund des Hilfs-Substratkörpers kann der gekrümmte Wirkbereich auch über den Substratkörper hinausgehen, ohne dass der Verlauf des gekrümmten Wirkbereichs beeinträchtigt oder nennenswert beeinträchtigt wird. Damit ist sichergestellt, dass der gekrümmte Wirkbereich auch im oberflächennahen Bereich des Substratkörpers nicht von der gewünschten Form abweicht, und dass das Substratmaterial entsprechend der Vorgabe räumlich beeinflusst wird.

Insbesondere wenn der Hilfs-Substratkörper und der Substratkörper aus gleichem Material sind, ist sichergestellt, dass an der Grenzfläche zwischen beiden Körpern ein nahtloser und vor allem versatzloser Übergang des gekrümmten Wirkbereichs besteht.

Nach der nichtlinearen Wechselwirkung kann der oder die Hilfs-Substratkörper von dem Substratkörper entfernt werden. Damit wird der eigentliche Substratkörper mit beeinflusstem Substratmaterial wieder freigelegt.

Mit anderen Worten, wenn der Hilfs-Substratkörper nach der nichtlinearen Wechselwirkung wieder entfernt wird, kann in dem Substratkörper eine saubere Beeinflussung bis zur Außenoberfläche des Substratkörpers erreicht werden.

Es können ein oder mehrere Hilfs-Substratkörper vorgesehen werden.

Der oder die Hilfs-Substratkörper können den Substratkörper umgeben, ihn sozusagen von einer oder mehreren Seiten umschließen.

Durch den Hilfs-Substratkörper wird zuverlässig vermieden, dass infolge von Ablationseffekten Ansammlungen von Substratmaterial im Randbereich der ausgezeichneten Oberfläche auftreten.

Alternativ oder ergänzend kann auch vorgesehen sein, dass das Substratmaterial nacheinander oder ganz oder teilweise parallel in den einzelnen der mehreren gekrümmten Wirkbereichen dem elektromagnetischen Feld ausgesetzt wird,

dass das gesamte Substratmaterial innerhalb eines gekrümmten Wirkbereichs gleichzeitig dem elektromagnetischen Feld ausgesetzt wird,

dass die gekrümmten Wirkbereiche jeweils eine maximale Auslenkung von einem geraden Verlauf aufweisen, die mehr als 20 µm, mehr als 40 µm, mehr als 60 µm, mehr als 80 µm oder mehr als 100 µm beträgt, und/oder

dass die Länge der gekrümmten Wirkbereiche jeweils mehr als 0,1 mm, mehr als 0,3 mm, mehr als 0,5 mm, mehr als 0,7 mm, mehr als 1 mm, mehr als 3 mm oder mehr als 5 mm beträgt.

Wenn das Substratmaterial nacheinander an den einzelnen gekrümmten Wirkbereichen dem elektromagnetischen Feld ausgesetzt wird, und damit also das Substratmaterial in den einzelnen Bereichen sequentiell beeinflusst wird, kann mit geringem technischen Aufwand die Strukturierung vorbereitet bzw. durchgeführt werden. Wenn das elektromagnetische Feld dann etwa mittels einen Linienfokus eines Lasers bereitgestellt wird, muss nur ein einziger Laser vorgehalten werden. Durch relatives Verfahren von Substratkörper und Linienfokus kann dann sehr einfach nacheinander der Linienfokus in den unterschiedlichen gekrümmten Wirkbereichen ausgebildet und dort das Substratmaterial beeinflusst werden.

Wenn das Substratmaterial in mehreren gekrümmten Wirkbereichen (oder sogar in allen) gleichzeitig einem elektromagnetischen Feld ausgesetzt wird, kann die Beeinflussung des Substratmaterials sehr zeiteffizient durchgeführt werden und damit die Strukturierung in reduzierter Zeit vorbereitet bzw. durchgeführt werden. So können mehrere Laser parallel an den unterschiedlichen Orten im Substratmaterial jeweils einen Linienfokus ausbilden und damit das Substratmaterial in mehreren gekrümmten Wirkbereichen parallel beeinflusst werden.

Ergänzend kann dann der Substratkörper relativ zu den mehreren Linienfoki verfahren werden, wenn die Beeinflussung des Substratmaterials in den entsprechenden gekrümmten Wirkbereichen abgeschlossen ist. So kann sequentiell an jeweils mehreren Stellen parallel das Substratmaterial beeinflusst werden. Dies ermöglicht eine besonders effiziente Möglichkeit der Strukturierung. Insbesondere skaliert das Prozedere für größere Substrate bzw. für umfangreichere Strukturierungsprozesse. Denn für umfangreichere Aufgaben können mehrere gekrümmte Wirkbereiche parallel ausgebildet werden, indem beispielsweise weitere Laser hinzugeschalten werden, die jeweils weitere Linienfoki im Substratmaterial ausbilden.

Im Fall eines Lasers wird der Linienfokus im Substratmaterial ausgebildet und dadurch der gekrümmte Wirkbereich bestimmt. Das heißt, der Bereich in dem der Linienfokus ein elektromagnetisches Feld innerhalb des Substratmaterials verursacht, ist der gekrümmte Wirkbereich. Insbesondere ist es der Teil des elektromagnetischen Felds, das eine nichtlineare Wechselwirkung mit dem Substratmaterial erzeugt.

Es ist freilich denkbar, dass der Linienfokus auch zum Teil außerhalb des Substratkörpers besteht, beispielsweise in einem den Substratkörper zumindest teilweise umgebenen Medium, wie einem Fluid, beispielsweise Luft oder eine Flüssigkeit, und/oder in einem Hilfs-Substratkörper. Dann besteht aber dennoch ein elektromagnetisches Feld auch innerhalb des Substratkörpers, so dass ein gekrümmter Wirkbereich in dem Substratkörper definierbar ist, auch wenn der gekrümmte Wirkbereich sich auch in dem anderen Medium fortsetzt.

Durch die Flexibilität des Verfahrens können gekrümmte Wirkbereiche mit jeweils angepasster Krümmung und/oder Länge erzeugt werden. So kann die Krümmung oder Länge kleiner oder größer ausfallen, je nachdem, wie die geplante Oberfläche strukturiert werden soll.

Ein gekrümmter Wirkbereich ist in dem Substratkörper vorzugsweise dreidimensional ausgebildet. Ein gekrümmter Wirkbereich hat vorzugsweise eine Haupterstreckungsrichtung innerhalb des Substratkörpers. Durch einen gekrümmten Wirkbereich kann eine Mittelachse gelegt werden, die ihrerseits einen gekrümmten Verlauf aufweisen kann. Die Länge dieser Mittelachse entspricht der Länge des gekrümmten Wirkbereichs. Diese Mittelachse hat ein Anfang und ein Ende in dem Substratmaterial. Vorzugsweise sind der Anfang und das Ende jeweils auf einer Oberfläche des Substratkörpers. Beispielsweise in den Schnittflächen zwischen dem Substratkörper und dem gekrümmten Wirkbereich. Die maximale Auslenkung des gekrümmten Wirkbereichs ist der maximale Abstand, den ein Punkt auf der Mittelachse von einem Punkt auf einer geraden Verbindungslinie zwischen dem Anfang und Ende der Mittelachse aufweisen kann.

Die räumliche Gestalt der gekrümmten Wirkbereiche und damit die räumliche Gestalt des beeinflussten Substratmaterials, mithin die Ausgestaltung der ausgezeichneten Oberfläche, ist abhängig von bzw. mitbestimmbar durch diese maximale Auslenkung, die auch als Profilhub bezeichnet werden kann.

Für die Einstellung der maximalen Auslenkung bzw. des Profilhubs kann die numerische Apertur A = n * sin (ALPHA) der fokussierenden Optik eingestellt und/oder angepasst werden. Allgemein gilt dabei: Je größer die numerische Apertur der fokussierenden Optik gewählt wird, desto kürzer wird die Länge des ausgebildeten Fokus und - im exemplarischen Falle eines Airy-Strahls - desto höher ist die Krümmung des Airy-Strahls in Fokusnähe.

Für den gekrümmten Wirkbereich bzw. die ausgezeichnete Oberfläche bedeutet dies, dass mit geringer werdender Dicke des Substratkörpers die lokale Krümmung erhöht werden muss, um einen nennenswerten Profilhub an der ausgezeichneten Oberfläche zu erzeugen.

Entsprechend kann das Verfahren zur Bearbeitung/Strukturierung von dünnen Substratkörpern eingesetzt werden. Dies gilt vor allem für die Strukturierung von deren Seitenfläche.

Dünne Substratkörper weisen vorzugsweise eine Substratdicke von 500 µm oder weniger, von 300 µm oder weniger oder von 100 µm oder weniger, vorzugsweise im Bereich 30 µm bis 100 µm, auf. Optional weisen dünne Substratkörper eine Substratdicke von 0,1 µm oder mehr, von 1 µm oder mehr, von 10 µm oder mehr, von 50 µm oder mehr, oder von 100 μm oder mehr auf. Während Substratkörper im Dickenbereich größer 1 mm mechanisch aufgespannt und ihre Seitenflächen mit herkömmlichen Verfahren poliert werden können, ist das bei dünnen Substratkörpern wegen ihrer (mechanischen) Instabilität und der Gefahr, dass die dünnen Substratkörper während des Polierens durch von der Seitenfläche einlaufende Risse infolge der eingetragenen mechanischen Spannung zerstört werden, herkömmlicherweise nicht möglich.

Erst das vorliegende Verfahren ermöglicht es erstmals, insbesondere ohne Kraftaufwand und daher ohne die Gefahr, den Substratkörper zu zerstören oder negativ zu beeinflussen, die Oberflächen selbst von dünnen Substratkörpern, insbesondere mit einer Dicke von 500 μm oder weniger, zu strukturieren. Insbesondere handelt es sich bei den Oberflächen um eine Seitenfläche des Substratkörpers, vorzugsweise einer umlaufenden Seitenfläche.

In einer Ausführungsform wird die numerische Apertur der zur Fokussierung des Lasers eingesetzten Optik in Abhängigkeit der Dicke des Substratmaterials eingestellt, um vorzugsweise eine Seitenfläche eines Substratkörpers, der eine Dicke von 500 μm oder weniger und/oder eine Dicke von 0,1 μm oder mehr aufweist, als ausgezeichnete Oberfläche strukturieren zu können.

In einer Ausführungsform kann die ausgezeichnete Oberfläche eine einstellbare Schräge aufweisen. Optional wird dies mittels eines versetzten und/oder gekippten, insbesondere vertikal versetzten bzw. verkippten, Airy-Strahls erreicht.

Vorzugsweise kommt dabei ein Airy-Strahl zum Einsatz, dessen Strahlschwerpunkt sich parallel zur optischen Achse/senkrecht zur Substratoberfläche, etwa einer Glasoberfläche, bewegt (Winkel Null Grad) und der (entlang der Propagationsrichtung/der Substratdicke) symmetrisch um die Mitte des Substrats verteilt ist. Das heißt, der Strahl hat genau dort seine maximale Auslenkung erreicht (Fokusposition). Im Fall des versetzten (unverkippten) Airy-Strahls wird der Fokus (und der Punkt der maximalen Auslenkung) abseits der Mitte (entlang der Dicke des Substrats) des Substrats gelegt. Im Fall des verkippten Airy-Strahls liegt die optische Achse (als Trajektorie des Strahlschwerpunkts) nicht parallel zur Normalen der Substratoberfläche.

In einer Ausführungsform wird eine bestehende Oberfläche, insbesondere Seitenfläche, des Substratkörpers angefast, insbesondere mit mehreren Überfahrten.

In einer Ausführungsform ist der Laserstrahl ein Airy-Strahl.

In einer Ausführungsform wird eine Kombination von Innen- und Außenflächen strukturiert, vorzugsweise zur Verwendung als ein Glasscharnier zur Verwendung in einem flexibel mobile device. Hierunter wird ein strukturiertes, zumeist streifenförmiges Glassubstrat mit der maximalen Dicke 200 μm, bevorzugt 100 μm oder weniger, besonders bevorzugt 20 μm verstanden, das aus einem mittleren, strukturierten Bereich, der sich zwischen 2 gegenüberliegenden Kanten des Substrates erstreckt, und zwei angrenzenden nicht strukturierten Bereichen besteht. Die verfahrensgemäß erzeugten Ausnehmungen des strukturierten Bereichs ermöglichen das reproduzierbare Biegen um eine Biegeachse senkrecht zur Orientierung des Glasstreifens.

Alternativ oder ergänzend kann auch vorgesehen sein, dass

(i) der Substratkörper transparent ist, aus Glas ist, eine erste Deckfläche aufweist und/oder eine zweite Deckfläche, die vorzugsweise parallel zur ersten Deckfläche verläuft und/oder ihr gegenüberliegt, aufweist,

(ii) die, vorzugsweise zwischen der ersten und zweiten Deckfläche gemessene, Dicke des Substratkörpers 500 μm oder weniger, vorzugsweise 400 μm oder weniger, noch bevorzugter 300 μm oder weniger, noch bevorzugter 200 μm oder weniger, noch bevorzugter 100 μm oder weniger, noch bevorzugter 70 μm oder weniger, noch bevorzugter 50 μm oder weniger, noch bevorzugter 30 μm oder weniger, am bevorzugtesten 10 μm oder weniger, beträgt, und/oder

(iii) nach dem Strukturieren der ausgezeichneten Oberfläche

1. die ausgezeichnete Oberfläche zwischen der ersten und zweiten Deckfläche verläuft,

2. die ausgezeichnete Oberfläche mit der ersten und/oder der zweiten Deckfläche zumindest bereichsweise verbunden ist,

3. zumindest ein Teil zumindest einer Seitenfläche, vorzugsweise einer umlaufenden Seitenfläche, des Substratkörpers die ausgezeichnete Oberfläche aufweist,

4. zumindest ein Teil einer Oberfläche eines Durchgangsloches, das sich vorzugsweise von der ersten Deckfläche zur zweiten Deckfläche erstreckt, die ausgezeichnete Oberfläche aufweist, und vorzugsweise das Durchgangsloch durch das Beeinflussen und/oder Ätzen des Substratmaterials ausgebildet wird,

5. zumindest ein Oberflächenbereich einer Kavität des Substratkörpers die ausgezeichnete Oberfläche aufweist, wobei die Kavität vorzugsweise von außen zugänglich ist oder komplett in dem Substratmaterial eingeschlossen ist, und vorzugsweise die Kavität durch das Beeinflussen und/oder Ätzen des Substratmaterials ausgebildet wird,

6. die ausgezeichnete Oberfläche zumindest bereichsweise eine nach innen zeigende Oberfläche des Substratkörpers darstellt,
und/oder

7. die ausgezeichnete Oberfläche zumindest bereichsweise eine nach außen zeigende Oberfläche des Substratkörpers darstellt.

Bisherige Verfahren konnten gerade bei transparenten Substratkörpern nur unzureichende Ergebnisse erzielen was die Effizienz und die Festigkeit der ausgebildeten Oberfläche angeht. Mit dem vorliegenden Verfahren können auch Oberflächen transparenter Substratkörper zuverlässig strukturiert werden.

Eine erste und zweite Deckfläche ermöglicht eine zuverlässige Beeinflussung des Substratmaterials, da die Deckfläche den Substratkörper klar begrenzt.

In einer Ausführungsform sind die erste und/oder zweite Deckfläche plan.

In einer Ausführungsform ist der Substratkörper quaderförmig.

In einer Ausführungsform ist der Substratkörper transparent mit einer ersten Deckfläche, einer zweiten Deckfläche und einer umlaufenden Seitenfläche, die zumindest bereichsweise gekrümmt ist entlang der Dickenrichtung des Substratkörpers.

Das Verfahren eignet sich besonders gut für die Strukturierung von Oberflächen dünner Substratkörper, das heißt für Substratkörper, deren Dicke gering ist. Und zwar insbesondere zur Strukturierung von Oberflächen, die eine Erstreckungsrichtung entlang der Dicke des Substratkörpers aufweisen, wie eine, vorzugsweise umlaufende, Seitenfläche des Substratkörpers.

Beispielsweise kann ein quaderförmiger Substratkörper eine geringe Dicke aufweisen. Dann lässt sich mit dem vorliegenden Verfahren sogar dessen Seitenfläche, oder ein Bereich davon, strukturieren, obwohl diese in einer Richtung nur die geringe Abmessung entsprechend der geringen Dicke aufweisen kann. Optional handelt es sich bei der Seitenfläche um eine umlaufende Seitenfläche.

In der vorliegenden Anmeldung gelten Substratkörper vorzugsweise dann als dünn bzw. weisen eine geringe Dicke auf, wenn die Stärke des Substratmaterials 500 $\mu$m oder weniger und/oder 10 $\mu$m und mehr beträgt.

Wenn die ausgezeichnete Oberfläche mit wenigstens einer der Deckflächen verbunden ist, kann ein besonders nahtloser Übergang zwischen bestehender und strukturierter Oberfläche hergestellt werden. Dies ermöglicht einen sehr stabilen Substratkörper.

Beispielsweise kann eine Seitenfläche des Substratkörpers, wie eine umlaufende Seitenfläche, mit dem vorliegenden Verfahren strukturiert werden, das heißt geformt werden. Dann ist die ausgezeichnete Oberfläche ein Teil dieser umlaufenden Seitenfläche.

Das Verfahren lässt sich besonders vielseitig einsetzen. Wenn sich beispielsweise ein gekrümmter Wirkbereich von einem Oberflächenbereich (zum Beispiel einer Deckfläche) zu einem anderen Oberflächenbereich (zum Beispiel zur anderen Deckfläche) erstreckt und damit entsprechend auch das beeinflusste Substratmaterial, kann ein Durchgangsloch von der einen zur anderen Deckfläche (allgemein: Oberflächenbereich) erzeugt werden, indem die ausgezeichnete Oberfläche strukturiert wird. Wenn sich beispielsweise ein gekrümmter Wirkbereich von einem Oberflächenbereich einer Deckfläche (zum Beispiel einem Oberflächenbereich) in das Substratmaterial hineinerstreckt, ohne sich zur anderen Oberfläche des Substratkörpers (zum Beispiel anderen Deckfläche des Substratkörpers) zu erstrecken und sich damit entsprechend auch das beeinflusste Material von einem Oberflächenbereich in das Substratmaterial hineinerstreckt, kann eine Kavität in der einen Oberfläche (allgemein: Deckfläche) erzeugt werden, indem die ausgezeichnete Oberfläche strukturiert wird. Wenn das beeinflusste Substratmaterial nicht bis nach außen reicht, kann sogar eine komplett eingeschlossene Kavität in dem Substratkörper erzeugt werden, indem die ausgezeichnete Oberfläche strukturiert wird.

Abgesehen von dem Fall der eingeschlossenen Kavität kann das beeinflusste Material wahlweise direkt durch das Beeinflussen entfernt werden und/oder durch beispielsweise einen nachfolgenden Ätzvorgang.

Mit dem vorliegenden Verfahren kann beispielsweise aus einem dünnen quaderförmigen Substratkörper eine kreisrunde Öffnung herausgeschnitten werden, indem eine ausgezeichnete Oberfläche strukturiert wird, die in wenigstens einer in dem Dickenbereich des Substratkörpers liegende Querschnittsebene eine kreisförmige Kontur aufweist.

Mit dem vorliegenden Verfahren kann beispielsweise bei einem dünnen quaderförmigen Substratkörper eine äußere Seitenfläche strukturiert werden, beispielsweise konvex oder konkav geformt werden.

In einer Ausführungsform weist das Strukturieren der ausgezeichneten Oberfläche auf, dass eine äußere Seitenfläche eines Substratkörpers, insbesondere eines dünnen, quaderförmigen Substratkörpers, konvex geformt wird.

Alternativ oder ergänzend kann auch vorgesehen sein, dass nach dem Strukturieren der ausgezeichneten Oberfläche sich der erste gekrümmte Verlauf der ausgezeichneten Oberfläche senkrecht zur Haupterstreckungsrichtung der ausgezeichneten Oberfläche erstreckt, und/oder dass in Haupterstreckungsrichtung der ausgezeichneten Oberfläche, insbesondere in umfänglicher Richtung des Substratkörpers, die ausgezeichnete Oberfläche zumindest bereichsweise einen zweiten gekrümmten Verlauf aufweist.

Wenn eine Seitenfläche eines runden oder quaderförmigen Substratkörpers strukturiert wird und damit die ausgezeichnete Oberfläche darstellt, kann die Seitenfläche eine Krümmung entlang der Dicke des Substratkörpers aufweisen, wobei die Krümmung zumindest bereichsweise durch die Krümmung des gekrümmten Wirkbereichs mitbestimmt oder bestimmt wird. Dies ist der erste gekrümmte Verlauf. Und dieser erstreckt sich senkrecht zur Haupterstreckungsrichtung der Seitenfläche des Substratkörpers, welche beispielsweise eine umlaufende Seitenfläche darstellt.

Im Fall des runden Substratkörpers verläuft die Seitenfläche entsprechend auch gekrümmt, um den Substratkörper herum, was hierbei den zweiten gekrümmten Verlauf darstellt.

In einer Ausführungsform ist durch ein Rotieren des Linienfokus um 180°, vorzugsweise um wenigstens eine Achse, die insbesondere parallel zur Haupterstreckungsrichtung des Linienfokus verläuft, ein zumindest bereichsweise konkaver oder konvexer erster gekrümmter Verlauf einstellbar.

Alternativ oder ergänzend kann auch vorgesehen sein, dass nach dem Strukturieren der ausgezeichneten Oberfläche in wenigstens einer Querschnittsebene des Substratkörpers die ausgezeichnete Oberfläche eine Kontur aufweist, die entlang des ersten gekrümmten Verlaufs

(i) zumindest abschnittsweise konvex oder konkav gekrümmt ist,

(ii) zumindest abschnittsweise einer Kontur des gekrümmten Wirkbereichs entspricht, und/oder

(iii) zumindest abschnittsweise einen parabolischen Verlauf, einen quartischen Verlauf, einen logarithmischen Verlauf, einen Verlauf gemäß einer polynomialen Funktion des Grades n, vorzugsweise mit geradem n, insbesondere mit n=6, n=8, n=10 oder n=12, und/oder einen C-förmigen Verlauf aufweist.

Der Linienfokus kann durch Einstellen entsprechender Phasen vielfältige Formen annehmen und damit vielfältige dreidimensionale Wirkbereiche ausbilden und darin das Substratmaterial beeinflussen. Beispielsweise kann das Substratmaterial in mehreren benachbarten Wirkbereichen beeinflusst werden, um anschließend die ausgezeichnete Oberfläche als neue Seitenfläche des strukturierten Substratkörpers vorliegen zu haben. Dabei kann der gekrümmte Wirkbereich so gewählt werden, dass die Krümmung in das Substratmaterial des nach dem Strukturieren gewünschten Substratkörpers hineinragt, um eine konkav geformte ausgezeichnete Oberfläche zu erhalten. Oder es kann der gekrümmte Wirkbereich sozusagen um 180 Grad rotiert werden, um eine konvex geformte ausgezeichnete Oberfläche zu erhalten.

Dies macht es besonders einfach möglich, das vorliegende Verfahren für das Strukturieren von unterschiedlich geformten ausgezeichneten Oberflächen einzusetzen.

Verschiedene Ausprägungen einer konvex gekrümmten Ober-/Seitenfläche können je nach späterer Anwendung von Vorteil sein: So ermöglicht eine parabolische/kubische Phase eine Ober-/Seitenfläche, die dem in der Glasindustrie üblichen C-Schliff der Ober-/Seitenfläche nahekommt, wohingegen eine quartische Phasenfunktion eher der an Ober-und Unterseite angephasten Ober-/Seitenfläche entspricht (anstatt einer Ober-/Seitenfläche mit kontinuierlich gekrümmter Form). Verschiedenste asymmetrische Ober-/Seitenflächenformen sind ebenfalls realisierbar durch Verkippen der Strahlachse und/oder Versetzen des Fokus gegenüber dem Substratkörper. Derartige Ober-/Seitenfläche werden beispielsweise eingesetzt, wenn eine autozentrierende Wirkung in der Anwendung des Substratkörpers relevant wird.

Ebenso ist es möglich die Ober-/Seitenfläche dickere Gläser abschnittsweise in mehreren Durchgängen zu bearbeiten.

Die Aufgabe wird durch die Erfindung gemäß einem zweiten Aspekt dadurch gelöst, dass ein Substratkörper, aufweisend wenigstens eine erste Deckfläche und wenigstens eine, insbesondere mit einem Verfahren gemäß dem ersten Aspekt der Erfindung hergestellte oder herstellbare, ausgezeichnete Oberfläche, wobei die ausgezeichnete Oberfläche zumindest bereichsweise wenigstens einen ersten gekrümmten Verlauf aufweist, wobei der erste gekrümmte Verlauf in einer Querschnittsebene des Substratkörpers liegt, die durch eine Ebene, die wenigstens einen Normalenvektor der ausgezeichneten Oberfläche und einen Normalenvektor der Deckfläche aufweist, aufgespannt wird, wobei der erste gekrümmte Verlauf zumindest bereichsweise durch eine parabolische, quartäre, logarithmische und/oder polynomische Phasenfunktion beschrieben werden kann,

wobei der Substratkörper eine Dicke von 500 $\mu$m oder weniger aufweist vorgeschlagen wird.

Es wird erstmalig ein Substratkörper bereitgestellt, der trotz seiner geringen Dicke eine Oberfläche, nämlich die ausgezeichnete Oberfläche, aufweist, die in der Querschnittsebene mit einer gekrümmten Kontur strukturiert ist.

Gerade für Oberflächen, die eine seitliche Oberfläche des Substratkörpers darstellen, war dies bisher nicht möglich.

Denn Substratkörper, die eine Dicke von 500 $\mu$m oder weniger aufweisen, zeigen die Tendenz, sich unter ihrem eigenen Gewicht zu verbiegen, wenn sie eingespannt werden. Dieses Verhalten ist ganz ähnlich wie bei einem Blatt Papier. Daher werden solche Substratkörper auch als MicroSheets bezeichnet.

Aufgrund dieses Verhaltens konnten solch dünne Substratkörper bisher nicht mechanisch eingespannt werden, um beispielsweise die herkömmlicherweise notwendigen Poliermaßnahmen einer bearbeiteten Oberfläche durchführen zu können. Da das erfindungsgemäße Verfahren bereits von sich aus ausgezeichnete Oberflächen von hoher Qualität bereitstellt, sind keine Poliermaßnahmen notwendig.

Das elektromagnetische Feld kann auch innerhalb eines sehr dünnen Substratkörpers ausgebildet und dort entsprechend das Substratmaterial beeinflusst werden. Dadurch können selbst sehr empfindliche, da dünne, Substratkörper mit strukturierten ausgezeichneten Oberflächen zuverlässig bereitgestellt werden. Dies ist optimal für Microsheets.

Der Substratkörper weist vorzugsweise eine Substratdicke von 400 $\mu$m oder weniger, von 300 $\mu$m oder weniger, von 200 $\mu$m oder weniger, von 100 $\mu$m oder weniger, von 50 $\mu$m oder weniger, von 20 $\mu$m oder weniger auf, oder von 10 $\mu$m oder weniger auf.

Der Substratkörper weist vorzugsweise eine Substratdicke von 1 $\mu$m oder mehr, von 10 $\mu$m oder mehr, von 50 $\mu$m oder mehr, oder von 100 $\mu$m oder mehr auf.

In einer Ausführungsform weist die Schmalseite des Substratkörpers eine sphärische Form in Form eines C-Schliffs aufweist.

In einer Ausführungsform verläuft die Krümmung der Schmalseite des Substrats zumindest entlang einer Richtung und/oder bereichsweise gemäß einer parabolischen, polynominalen oder logarithmischen Form und/oder ist durch das Intensitätsprofil eines quartic-beams vorgegeben.

In einer Ausführungsform weist das Substratkörper wenigstens eine Modifikation im Innern auf, wobei vorzugsweise eine Modifikation eine räumlich begrenzte Variation der Dichte und/oder des Brechungsindex des Substratmaterials ist, eine Kavität, ein Riss und/oder ein Durchgangsloch in dem Substratmaterial aufweist, vorzugsweise versehen mit einer geformten Außen-/Innenkontur und/oder einem Taperwinkel. Optional kann die Modifikation im Innern von Konturen unterschiedlicher Art begrenzt sein, wie etwa ungekrümmt oder gekrümmt. Außerdem kann die Modifikation mindestens eine, beide oder keine der Deckflächen des Substratkörpers durchstoßen.

In einer Ausführungsform ist die Rauheit der ausgezeichneten Oberfläche Ra kleiner gleich 5 $\mu$m, vorzugsweise kleiner gleich 2 $\mu$m, noch bevorzugter kleiner gleich 1 $\mu$m. Beispielsweise ist die Rauheit eine mittlere Rauheit, die vorzugsweise gemäß der ISO 25178: 2016 gemessen wird.

In einer Ausführungsform weist die ausgezeichnete Oberfläche eine Riefenstruktur auf.

In einer Ausführungsform weist der Substratkörper zwei oder mehr Schichten und eine gekrümmte Seitenfläche auf. Optional kann der Substratkörper mit einem funktionalen Bauteil als Ganzes bearbeitet werden.

In einer Ausführungsform ist der Substratkörper aus Glas, Glaskeramik, Silizium oder Saphir oder weist dieses auf.

In einer Ausführungsform weist der Substratkörper keine Ansammlungen von Substratmaterial im Randbereich der ausgezeichneten Oberfläche auf.

Alternativ oder ergänzend kann auch vorgesehen sein, dass die ausgezeichnete Oberfläche eine Festigkeit von wenigstens 100 MPa, vorzugsweise von wenigstens 150 MPa, noch bevorzugter von wenigstens 200 MPa, aufweist, wobei vorzugsweise die ausgezeichnete Oberfläche ganz oder teilweise geätzt wurde, insbesondere mit Flusssäure, Natriumhydroxid, einer Lauge, wie einer Kalilauge, und/oder einer Säure.

Durch eine hohe Festigkeit der ausgezeichneten Oberfläche ist der Substratkörper widerstandsfähig gegen auf die ausgezeichnete Oberfläche einwirkende äußere Einflüsse, wie mechanische Beanspruchung. Dies ist gerade für dünne Substratkörper ein großer Vorteil, da diese so stabilisiert werden können.

Das erfindungsgemäße Verfahren stellt eine solche ausgezeichnete Oberfläche zur Verfügung. Denn die bei herkömmlichen Verfahren entstehenden Schädigungen, wie Mikrorisse oder dergleichen, treten bei dem vorgeschlagenen Verfahren nicht auf, zumal diese bekannten Verfahren bei Substratkörpern der hier gegenständlichen Dicke schon gar nicht anwendbar sind.

Wenn die ausgezeichnete Oberfläche ganz oder teilweise geätzt wurde, lässt sich die Festigkeit nochmals steigern.

Alternativ oder ergänzend kann auch vorgesehen sein, dass die ausgezeichnete Oberfläche zumindest bereichsweise höhenmoduliert ist, insbesondere eine wellenartige und/oder kalottenförmige Struktur aufweist, vorzugsweise entlang der Haupterstreckungsrichtung der ausgezeichneten Oberfläche und/oder senkrecht dazu.

Durch die Höhenmodulation kann die Festigkeit der ausgezeichneten Oberfläche gesteigert werden. Dadurch ist der Substratkörper widerstandsfähig gegen auf die ausgezeichnete Oberfläche einwirkende äußere Einflüsse, wie mechanische Beanspruchung. Dies ist gerade für dünne Substratkörper ein großer Vorteil, da diese so zusätzlich stabilisiert werden können.

Bisher war es nicht möglich, insbesondere bei Seitenflächen dünner Substratkörper, solch eine Höhenmodulation sicher und zuverlässig vorzusehen. Aufgrund der mechanischen Instabilität der dünnen Substratkörper konnten die dafür notwendigen Prozesse, wie insbesondere Schleifen, an solchen Substraten herkömmlicherweise nicht durchgeführt werden. Mit dem vorgeschlagenen Verfahren ist es nunmehr möglich, selbst sehr dünne Substratkörper zu strukturieren, gerade auch ihre Seitenfläche, und dabei eine Höhenmodulation einzuarbeiten.

So lässt sich ein Höhenprofil besonders einfach und zuverlässig realisieren, indem beispielsweise das Substratmaterial in mehreren gekrümmten Wirkbereichen beeinflusst wird. Wenn das Substratmaterial in den gekrümmten Wirkbereichen entfernt wurde, etwa durch die Beeinflussung selbst oder durch einen anschließenden Ätzvorgang, können beispielsweise durch anschließendes Ätzen die einzelnen Hohlräume im Substratkörper miteinander verbunden werden, indem das unbeeinflusste Substratmaterial zwischen den einzelnen Hohlräumen weggeätzt wird. Dadurch lässt sich die charakteristische wellenartige Struktur entlang der Haupterstreckungsrichtung der ausgezeichneten Oberfläche erreichen.

Vorzugsweise verläuft die Haupterstreckungsrichtung der ausgezeichneten Oberfläche senkrecht zur Haupterstreckungsrichtung der gekrümmten Wirkbereiche.

Alternativ oder ergänzend kann auch vorgesehen sein, dass

(i) der Substratkörper transparent ist, aus Glas ist und/oder eine zweite Deckfläche, die vorzugsweise parallel zur ersten Deckfläche verläuft und/oder ihr gegenüberliegt, aufweist,

(ii) die, vorzugsweise zwischen der ersten und zweiten Deckfläche gemessene, Dicke des Substratkörpers 500 $\mu$m oder weniger, vorzugsweise 400 $\mu$m oder weniger, noch bevorzugter 300 $\mu$m oder weniger, noch bevorzugter 200 $\mu$m oder weniger, noch bevorzugter 100 $\mu$m oder weniger, noch bevorzugter 70 $\mu$m oder weniger, noch bevorzugter 50 $\mu$m oder weniger, noch bevorzugter 30 $\mu$m oder weniger, am bevorzugtesten 10 $\mu$m oder weniger, beträgt, und/oder (iii)

1. die ausgezeichnete Oberfläche zwischen der ersten und zweiten Deckfläche verläuft,

2. die ausgezeichnete Oberfläche mit der ersten und/oder der zweiten Deckfläche zumindest bereichsweise verbunden ist,

3. zumindest ein Teil zumindest einer Seitenfläche, vorzugsweise einer umlaufenden Seitenfläche, des Substratkörpers die ausgezeichnete Oberfläche aufweist,

4. zumindest ein Teil einer Oberfläche eines Durchgangsloches, das sich vorzugsweise von der ersten Deckfläche zur zweiten Deckfläche erstreckt, die ausgezeichnete Oberfläche aufweist, und vorzugsweise das Durchgangsloch durch Beeinflussen und/oder Ätzen des Substratmaterials ausgebildet ist,

5. zumindest ein Oberflächenbereich einer Kavität des Substratkörpers die ausgezeichnete Oberfläche aufweist, wobei die Kavität vorzugsweise von außen zugänglich ist oder komplett in dem Substratmaterial eingeschlossen ist, und vorzugsweise die Kavität durch Beeinflussen und/oder Ätzen des Substratmaterials ausgebildet ist,

6. die ausgezeichnete Oberfläche zumindest bereichsweise eine nach innen zeigende Oberfläche des Substratkörpers darstellt, und/oder

7. die ausgezeichnete Oberfläche zumindest bereichsweise eine nach außen zeigende Oberfläche des Substratkörpers darstellt.

Alternativ oder ergänzend kann auch vorgesehen sein, dass sich der erste gekrümmte Verlauf der ausgezeichneten Oberfläche senkrecht zur Haupterstreckungsrichtung der ausgezeichneten Oberfläche erstreckt, und/oder dass in Haupterstreckungsrichtung der ausgezeichneten Oberfläche, insbesondere in umfänglicher Richtung des Substratkörpers, die ausgezeichnete Oberfläche zumindest bereichsweise einen zweiten gekrümmten Verlauf aufweist.

Alternativ oder ergänzend kann auch vorgesehen sein, dass in wenigstens einer Querschnittsebene des Substratkörpers die ausgezeichnete Oberfläche eine Kontur aufweist, die entlang des ersten gekrümmten Verlaufs

(i) zumindest abschnittsweise konvex oder konkav gekrümmt ist,

(ii) zumindest abschnittsweise einer Kontur des gekrümmten Wirkbereichs entspricht, und/oder

(iii) zumindest abschnittsweise einen parabolischen Verlauf, einen quartischen Verlauf, einen logarithmischen Verlauf, einen Verlauf gemäß einer polynomialen Funktion des Grades n, vorzugsweise mit geradem n, insbesondere mit n=6, n=8, n=10 oder n=12, und/oder einen C-förmigen Verlauf aufweist.

Diese Merkmale wurden bereits bei den korrespondierenden Merkmalen des ersten Aspekts der Erfindung beschrieben. Die Erläuterungen gelten hier mutatis mutandis. Daher kann auf die dort gemachten Ausführungen verwiesen werden.

Die Aufgabe wird durch die Erfindung gemäß einem dritten Aspekt dadurch gelöst, dass ein Substratkörper, vorzugsweise gemäß dem zweiten Aspekt der Erfindung,

wobei der Substratkörper zumindest bereichsweise wenigstens eine räumliche Modifikation seines Substratmaterials, wie eine Änderung des Brechungsindex, eine Änderung der Dichte und/oder einen Hohlraum, aufweist,

wobei die Modifikation in einer Querschnittsebene des Substratkörpers zumindest bereichsweise eine gekrümmte Kontur aufweist,

wobei vorzugsweise sich die Modifikation von einer ersten Deckfläche des Substratkörpers in das Substratmaterial hinein erstreckt, insbesondere in Richtung und/oder bis zu einer, vorzugsweise der ersten Deckfläche gegenüberliegenden und/oder parallel zu dieser verlaufenden, zweiten Deckfläche des Substratkörpers,

wobei vorzugsweise der Substratkörper eine Dicke von 500 μm oder weniger aufweist, die insbesondere zwischen der ersten und der zweiten Deckfläche des Substratkörpers gemessen wird, vorgeschlagen wird.

Es wird erstmalig ein Substratkörper bereitgestellt, der trotz seiner geringen Dicke eine entsprechende Modifikation aufweisen kann, die in der Querschnittsebene mit einer gekrümmten Kontur strukturiert ist.

Gerade für solch dünne Substratkörper war dies bisher nicht möglich. Hier treten herkömmlicherweise die gleichen Probleme auf, wie sie oben bezüglich des zweiten Aspekts der Erfindung beschrieben wurden.

Das elektromagnetische Feld kann auch innerhalb eines sehr dünnen Substratkörpers ausgebildet und dort entsprechend das Substratmaterial beeinflusst werden. Dadurch können selbst sehr empfindliche, da dünne, Substratkörper mit solchen Modifikationen versehen werden. Dies ist optimal für Microsheets.

Eine Modifikation kann beispielsweise eine Änderung des Brechungsindex und/oder der Dichte des Substratmaterials sein. Eine Modifikation kann auch ein Hohlraum in dem Substratmaterial sein.

Der Substratkörper weist vorzugsweise eine Substratdicke von 400 μm oder weniger, von 300 μm oder weniger, von 200 μm oder weniger, von 100 μm oder weniger, von 50 μm oder weniger, oder von 10 μm oder weniger auf.

Der Substratkörper weist vorzugsweise eine Substratdicke von 0,1 μm oder mehr, von 1 μm oder mehr, von 10 μm oder mehr, von 50 μm oder mehr, oder von 100 μm oder mehr auf.

In einer Ausführungsform ist der Substratkörper aus Glas, Glaskeramik, Silizium oder Saphir oder weist dieses auf.

Alternativ oder ergänzend kann auch vorgesehen sein, dass die Modifikation eine maximale Auslenkung von einem geraden Verlauf aufweist, die mehr als 20 μm, mehr als 40 μm, mehr als 60 μm, mehr als 80 μm oder mehr als 100 μm beträgt,

und/oder

dass die Länge der Modifikation jeweils mehr als 0,1 mm, mehr als 0,3 mm, mehr als 0,5 mm, mehr als 0,7 mm, mehr als 1 mm, mehr als 3 mm oder mehr als 5 mm beträgt.

Diese Merkmale wurden bereits bei den korrespondierenden Merkmalen des ersten Aspekts der Erfindung beschrieben. Die Erläuterungen gelten hier mutatis mutandis. Daher kann auf die dort gemachten Ausführungen verwiesen werden.

Kurzbeschreibung der Figuren

Weitere Merkmale und Vorteile der Erfindung ergeben sich aus der nachfolgenden Beschreibung, in der bevorzugte Ausführungsformen der Erfindung anhand schematischer Zeichnungen erläutert werden.

Dabei zeigen:

Fig. 1 einen ersten Substratkörper in einer Aufsicht;

Fig. 2 den ersten Substratkörper in einer ersten Querschnittsansicht;

Fig. 3 den ersten Substratkörper in einer zweiten Querschnittsansicht;

Fig. 4a        den ersten Substratkörper mit beeinflusstem Substratmaterial in einer Aufsicht;

Fig. 4b        den ersten Substratkörper mit beeinflusstem Substratmaterial in einer Seitenansicht;

Fig. 5        unterschiedliche Verläufe der Seitenfläche des ersten Substratkörpers nach einem Ätzvorgang in der Querschnittsebene der ersten Querschnittsansicht;

Fig. 6a        den ersten Substratkörper nach dem Ätzvorgang in der Querschnittsebene der ersten Querschnittsansicht;

Fig. 6b        den ersten Substratkörper nach einem Ätzvorgang in der Querschnittsebene der zweiten Querschnittsansicht;

Fig. 7a        einen zweiten Substratkörper in einer Aufsicht;

Fig. 7b        den zweiten Substratkörper in einer Querschnittsansicht;

Fig. 8a        einen dritten Substratkörper in einer Aufsicht;

Fig. 8b        den dritten Substratkörper in einer Querschnittsansicht;

Fig. 9        den Einfluss der Brennweite der Fokussieroptik bei einem Laserstrahl;

Fig. 10        Linienfoki für unterschiedliche Laserleistungen;

Fig. 11        verschiedene Linienfoki in einem Substratkörper; und

Fig. 12a-12c    Linienfoki für unterschiedliche Phasenfunktionen.

Beispiele

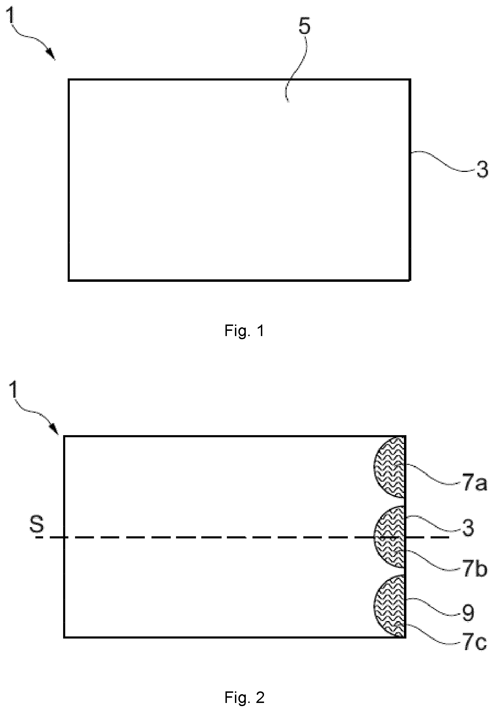

Figur 1 zeigt einen quaderförmigen, transparenten Substratkörper 1 in einer Aufsicht. Der Substratkörper 1 ist aus Glas, das heißt, sein Substratmaterial ist aus Glas.

Die in Figur 1 rechte Seitenfläche 3 des Substratkörper 1 soll strukturiert werden. Das heißt, die Seitenfläche 3 soll eine neue Gestalt erhalten.

Figur 2 zeigt den Substratkörper 1 in einer Querschnittsansicht, wobei die Querschnittsebene parallel zur ersten Deckfläche 5 des Substratkörpers 1 verläuft.

Um die neue Oberfläche der bisher unstrukturierten Seitenfläche 3 zu strukturieren, wird das Substratmaterial des Substratkörpers 1 in mehreren gekrümmten Wirkbereichen 7a-7c gleichermaßen einem elektromagnetischen Feld ausgesetzt, das dort jeweils eine nichtlineare Wechselwirkung mit dem Substratmaterial bewirkt. Infolge der nichtlinearen Wechselwirkung wird das Substratmaterial im Bereich der gekrümmten Wirkbereiche 7a-7c beeinflusst. Das Beeinflussen geht mit einer Veränderung des Brechungsindex des Substratmaterials einher.

Das elektromagnetische Feld ist dabei jeweils das eines innerhalb des Substratmaterials ausgebildeten Linienfokus eines Lasers. Indem der Linienfokus relativ zu dem Substratkörper 1 verfahren wird, wird der Linienfokus des Lasers nacheinander in unterschiedlichen Bereichen des Substratmaterials ausgebildet. Das heißt, es wird sequentiell erst in dem gekrümmten Wirkbereich 7a, dann in dem gekrümmten Wirkbereich 7b und anschließend in dem gekrümmten Wirkbereich 7c das Substratmaterial beeinflusst.

Das elektromagnetische Feld des Linienfokus entspricht dabei gerade dem einzelnen gekrümmten Wirkbereich. Und der einzelne gekrümmte Wirkbereich entspricht jeweils dem Bereich mit beeinflusstem Substratmaterial.

Der Laserstrahl kann durch einen Spatial Light Modulator propagiert sein und abhängig von der aufgeprägten Phase ist auch der Linienfokus gekrümmt und damit der jeweilige gekrümmte Wirkbereich gestaltet.

Die einzelnen gekrümmten Wirkbereiche sind beabstandet zueinander angeordnet. In der Querschnittsebene der Figur 2 verlaufen die (nicht dargestellten) Schwerpunkte der Schnittflächen von gekrümmten Wirkbereichen 7a-7c und der Querschnittsebene entlang einer Geraden, die parallel zur Kante 9 der Seitenfläche 3 verläuft.

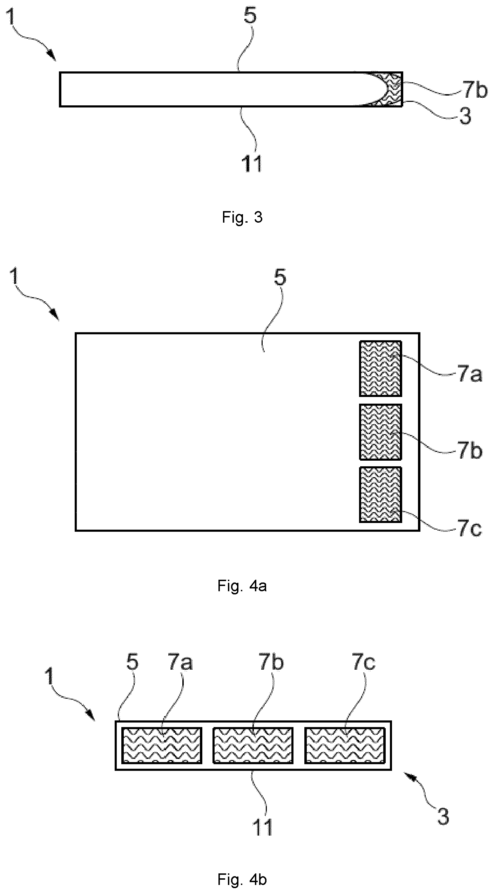

Figur 3 zeigt den Substratkörper 1 in einer anderen Querschnittsansicht, wobei die Querschnittsebene senkrecht zur ersten Deckfläche 5 des Substratkörpers 1 verläuft und die Querschnittsansicht der Figur 2 in der dort gestrichelt dargestellten Schnittlinie S schneidet. Die sichelförmige Gestalt des gekrümmte Wirkbereichs 7b ist in Figur 3 zu erkennen. Die übrigen gekrümmten Wirkbereiche, die allerdings in Figur 3 nicht zu sehen sind, weisen in einer entsprechenden parallelen Querschnittsebene eine gleiche Gestalt auf.

Würde die jeweilige Querschnittsebene in den Figuren 2 und 3 jeweils parallel verschoben werden, so würde sich auch die Gestalt der Schnittfläche mit dem bzw. den gekrümmten Wirkbereichen ändern. Wie genau, hängt von der dreidimensionalen Gestalt der gekrümmten Wirkbereiche ab. Die räumliche Gestalt der gekrümmten Wirkbereiche kann durch die Phase des Linienfokus eingestellt und angepasst werden.

Wie in Figur 3 weiter zu erkennen ist, schneiden die gekrümmten Wirkbereiche 7a-7c jeweils die erste Deckfläche 5, die zweite Deckfläche 11 und die zu strukturierende Seitenfläche 3 des Substratkörpers 1. Daher ist das beeinflusste Substratmaterial an den entsprechenden Schnittflächen von Substratkörper 1 und gekrümmten Wirkbereichen 7a-7c von außen zugänglich.

Figur 4a zeigt eine Aufsicht auf den Substratkörper 1. Dort sind die gekrümmten Wirkbereiche 7a-7c mit ihren Schnittflächen mit der ersten Deckfläche 5 sichtbar. Figur 4b zeigt den Substratkörper 1 von der Seite und damit die zu strukturierende Seitenfläche 3. Dort sind ebenfalls die gekrümmten Wirkbereiche 7a-7c mit ihren Schnittflächen mit der Seitenfläche 3 sichtbar.

Das beeinflusste Substratmaterial wird anschließend entfernt, indem selektives Laserätzen angewendet wird. Dazu wird der Substratkörper 1 zumindest lokal als Ätzmedium ausgesetzt.

Das laserselektive Ätzen ätzt sowohl beeinflusstes als auch unbeeinflusstes Substratmaterial von dem Substratkörper 1 weg. Allerdings wird das beeinflusste Substratmaterial schneller weggeätzt als das unbeeinflusste Substratmaterial.

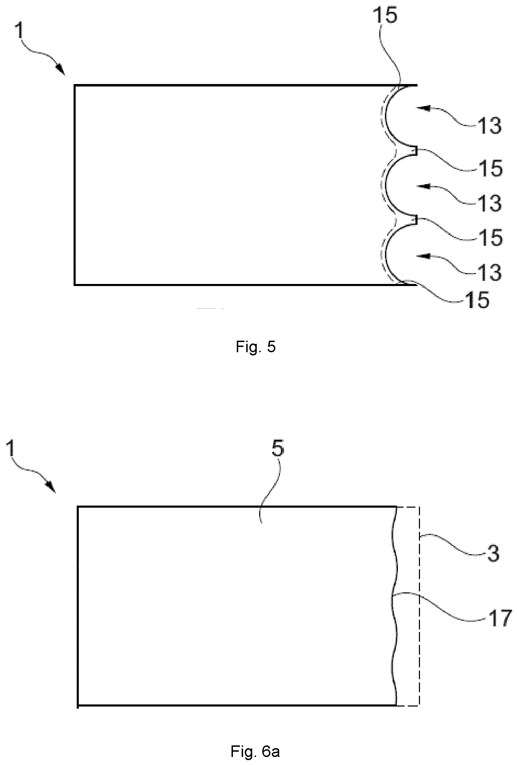

Figur 5 zeigt den Substratkörper 1 in der gleichen Querschnittsebene wie zuvor schon in Figur 2, allerdings nach dem Ätzvorgang. Würde der Ätzvorgang nur beeinflusstes Substratmaterial entfernen, verliefe die Kontur des strukturierten Substratkörpers in der Querschnittsebene der Figur 5 gemäß der durchgezogenen Linie. Die gekrümmten Wirkbereiche 7a-7c prägen in der Querschnittsebene der Figur 5 kreisförmige Konturen 13 in das Substratmaterial.

Da der Ätzvorgang aber auch unbeeinflusstes Material entfernt, ist auch das Substratmaterial 15 zwischen den einzelnen gekrümmten Wirkbereichen und im Randbereich teilweise weggeätzt. Dadurch sind insbesondere die Stege zwischen den Bereichen mit beeinflusstem Material entfernt. Außerdem ist aus dem gleichen Grund auch die kreisförmige Kontur 13 insgesamt in das Substratmaterial hineinverschoben, wie durch den leicht versetzten Verlauf der gestrichelten Linie angedeutet werden soll.

Die zuvor unstrukturierte Seitenfläche 3 des Substratkörpers 1 weist daher nach der Strukturierung in der Querschnittsebene der Figur 5 eine Kontur gemäß der gestrichelten Linie auf.

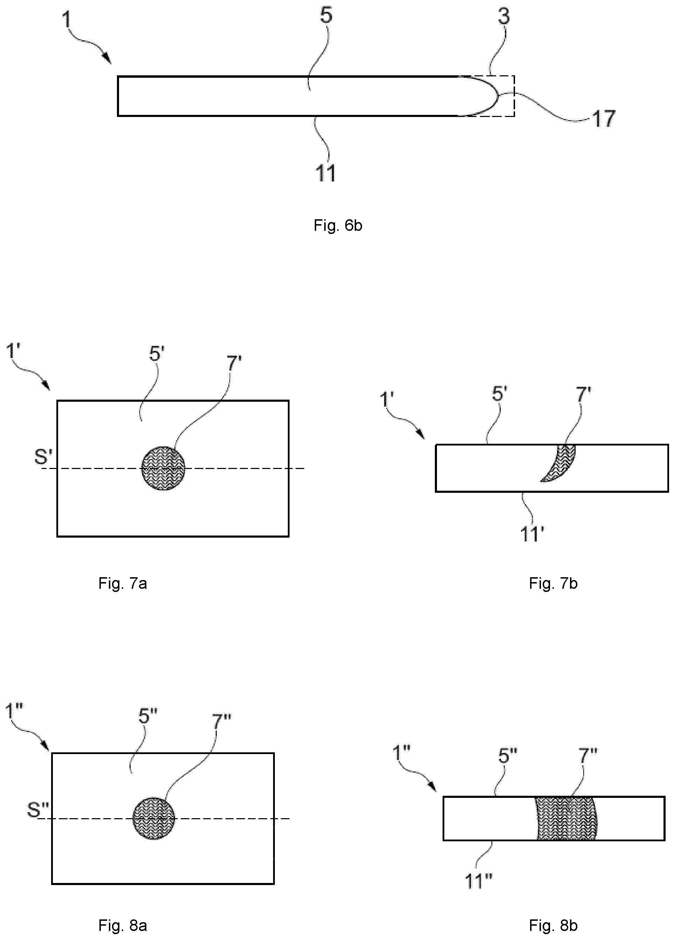

Figur 6a zeigt in der Querschnittsebene der Figur 2 und Figur 6b zeigt in der Querschnittsebene der Figur 3 den Verlauf der strukturierten Oberfläche 17 und gestrichelt dazu den Verlauf der ursprünglichen, unstrukturierten Oberfläche 3. Die strukturierte Oberfläche 17 ist in der Höhe moduliert und weist bereichsweise eine entsprechend der kalottenförmigen Vertiefungen kalottenförmige Struktur auf.

Die strukturierte Oberfläche 17 wird folglich ausgebildet, indem das beeinflusste Substratmaterial und außerdem auch unbeeinflusstes Substratmaterial durch Ätzen entfernt wird. Die strukturierte Oberfläche 17 ist eine ausgezeichnete Oberfläche im Sinne dieser Erfindung.

Die strukturierte Oberfläche 17 ist mit der ersten und der zweiten Deckfläche 5, 11 zumindest bereichsweise verbunden. Die strukturierte Oberfläche 17 ist eine äußere Oberfläche.

Der in Figur 6b gezeigte gekrümmte Verlauf der strukturierten Seitenfläche 17 ist konvex und entspricht einem ersten gekrümmten Verlauf. Der erste gekrümmte Verlauf wurde durch die Gestalt des gekrümmten Wirkbereiches 7b beeinflusst. Obwohl also der Ätzvorgang hier auch Anteile des unbeeinflussten Substratmaterials entfernt hat, ist der grundlegende Verlauf der strukturierten rechten Seitenfläche 17 des Substratkörpers 1 bereichsweise durch die gekrümmte Gestalt des jeweils dort angewendeten gekrümmten Wirkbereichs, hier gekrümmter Wirkbereich 7b, mitbestimmt. Da die gekrümmten Wirkbereiche 7a-7c an mehreren Stellen bei der Strukturierung der Oberfläche mitwirken, weist die strukturierte Oberfläche 17 an mehreren Bereichen den gleichen ersten gekrümmten Verlauf auf. Denn an mehreren Bereichen bestimmt bzw. beeinflusst die gekrümmte Gestalt der gekrümmten Wirkbereiche 7a-7c den Verlauf der strukturierten Oberfläche 17. Mit anderen Worten, der erste gekrümmte Verlauf wird durch die mehreren gekrümmten Wirkbereiche an mehreren Bereichen der strukturierten bzw. ausgezeichneten Oberfläche 17 erreicht.

Die erste und zweite Deckfläche 5, 11 des Substratkörpers 1 sind in den Figuren 3 und 6b parallel zueinander und weisen einen Abstand von 500 $\mu$m zueinander auf.

Wenn die gekrümmten Wirkbereiche 7a-7c um eine Achse senkrecht zur ersten Deckfläche 5 um 180° gedreht worden wären, wäre der erste gekrümmte Verlauf in der Querschnittsebene der Figur 6b konkav.

Wenn die gekrümmten Wirkbereiche 7a-7c von der zu strukturierenden Oberfläche 3 in Richtung Mitte des Substratkörpers 1 positioniert werden, lässt sich der Substratkörper 1 in zwei Teile teilen. An der Trennfläche weist der verbleibende Substratkörper dann bei einem entsprechenden Procedere wie oben beschrieben eine strukturierte Oberfläche wie die strukturierte Oberfläche 17 auf.

Figur 7a zeigt einen Substratkörper 1' in einer Aufsicht und Figur 7b zeigt den Substratkörper 1' in einer Querschnittsansicht, wobei die Querschnittsebene senkrecht zur ersten Deckfläche 5' des Substratkörpers 1' verläuft und die Querschnittsansicht der Figur 7a in der dort gestrichelt dargestellten Schnittlinie S' schneidet. In dem Substratkörper 1' wird nur in einem einzigen gekrümmten Wirkbereich 7' das Substratmaterial beeinflusst. Der gekrümmte Wirkbereich 7' erstreckt sich von der ersten Deckfläche 5' in Richtung der zweiten Deckfläche 11'. Wenn das beeinflusste Material weggeätzt wird, lässt sich eine Kavität in dem Substratkörper 1' erzeugen.

Deren Oberfläche ist die strukturierte Oberfläche und damit die ausgezeichnete Oberfläche. Diese ist dann eine innere Oberfläche.

Figur 8a zeigt einen Substratkörper 1" in einer Aufsicht und Figur 8b zeigt den Substratkörper 1' in einer Querschnittsansicht, wobei die Querschnittsebene senkrecht zur ersten Deckfläche 5" des Substratkörpers 1" verläuft und die Querschnittsansicht der Figur 8a in der dort gestrichelt dargestellten Schnittlinie S" schneidet. In dem Substratkörper 1" wird nur in einem einzigen gekrümmten Wirkbereich 7" das Substratmaterial beeinflusst. Der gekrümmte Wirkbereich 7" erstreckt sich von der ersten Deckfläche 5" bis zur zweiten Deckfläche 11". Wenn das beeinflusste Material weggeätzt wird, lässt sich ein Durchgangsloch, also ein Via, in dem Substratkörper 1" erzeugen. Dessen Oberfläche ist die strukturierte Oberfläche und damit die ausgezeichnete Oberfläche. Diese ist dann eine innere Oberfläche.

Einfluss der Brennweite der Fokussieroptik

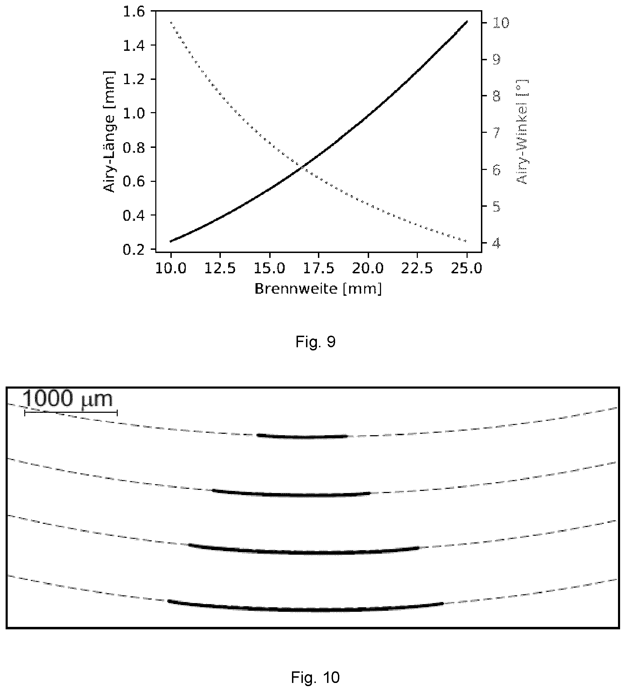

Fig. 9 illustriert den Einfluss der Brennweite der Fokussieroptik bei einem Airy-Laserstrahl. Für konstante

- Kubische Phase (mit beta = $3^{1/3} \times 10^3$/m);

- Laserwellenlänge (mit lambda = $1{,}030 \times 10^{-6}$ m); und

- Strahldurchmesser (Durchmesser des Rohstrahls $w_0 = 5 \times 10^{-3}$ m)

nimmt die Länge des Fokusbereichs (in relativer Definition: Abfall auf $1/e^2$ des Maximalwerts) mit steigender Brennweite zu (Kurve mit durchgezogener Linie in Fig. 9) und der Winkel, den der Fokus am oberen und unteren Ende jeweils zur optischen Achse hat, ab (Kurve mit gestrichelter Linie in Fig. 9). Die linke Ordinate bezieht sich folglich auf die durchgezogene Linie und die rechte Ordinate bezieht sich auf die gestrichelte Linie.

Einfluss der Laserleistung auf den Linienfokus

In Fig. 10 sind mit Linienfoki unterschiedlicher Laserleistung beeinflusste Materialbereiche in einem Glassubstrat dargestellt. Von oben nach unten nimmt die Laserleistung zu und damit die Ausdehnung des jeweiligen gekrümmten Wirkbereichs und somit der Bereich des beeinflussten Materials.

Einfluss einer Verkippung und Versetzung eines Linienfokus

Der Versatz bezieht sich auf die Entfernung des Scheitelpunkts des Fokusbereichs von der Mitte des Substratkörpers. Die Verkippung bezieht sich auf den Winkel zwischen Oberflächennormale und Tangente am Scheitelpunkt.

Bei einem zentrierten, unverkippten Airy-Strahl liegt der Scheitelpunkt des Fokusbereichs entlang der Normalen der Substratoberfläche in der Mitte des Substratkörpers, also in der Mitte seiner Dickenerstreckung, und die Oberflächennormale und die Tangente am Scheitelpunkt sind parallel.

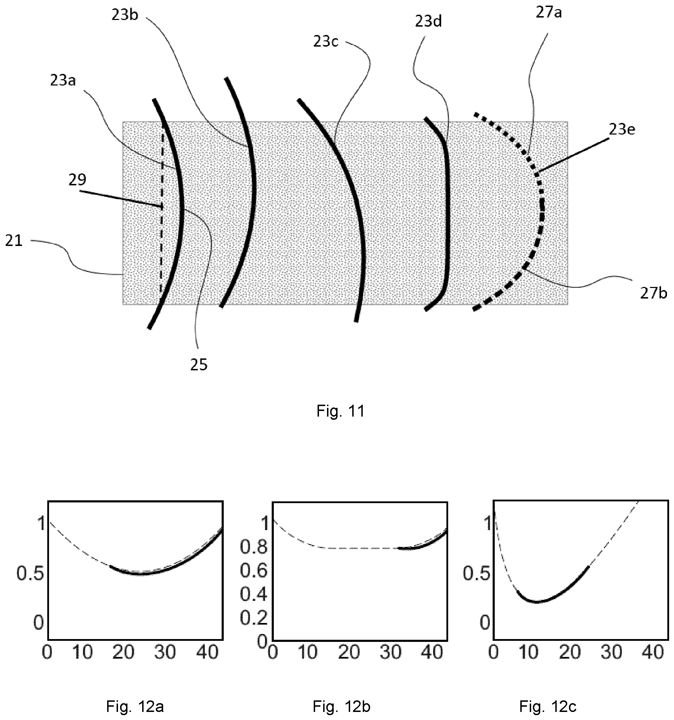

In Fig. 11 sind verschiedene, zumindest teilweise in einem Substratkörper 21 ausgebildete Linienfoki 23a-23e von Laserstrahlen dargestellt. Die Schnittebene der Fig. 11 zeigt den Dickenbereich des Substratkörpers 21.

Linienfokus 23a stellt einen Linienfokus dar, insbesondere eines Airy-Strahls, der zentriert ist und keine Verkippung aufweist. Der Linienfokus 23a weist einen Scheitelpunkt 25 des parabolischen Fokusbereichs 23a auf.

Linienfokus 23b zeigt einen Linienfokus, insbesondere eines Airy-Strahls, der versetzt ist.

Linienfokus 23c stellt einen Linienfokus dar, insbesondere eines Airy-Strahls, der verkippt und versetzt ist.

Linienfokus 23d stellt einen Linienfokus dar, insbesondere einer anderen Funktion als die eines Airy-Strahls, mit variabler Krümmung. Beispielsweise könnte die Krümmung ein C-Profil beschreiben.

Der Linienfokus 23e stellt einen Linienfokus dar, insbesondere eines Airy-Strahls oder einer anderen Funktion, der in einem ersten Bereich 27a einen oberen Teil des Substratmaterials 1 modifiziert und der in einem zweiten Bereich 27b einen unteren Teil des Substratmaterials 1 modifiziert.

In Fig. 11 lässt sich auch die Länge der einzelnen Linienfoki 23a-23e als die Länge des dargestellten gekrümmten Verlaufs, insbesondere innerhalb des Substratkörpers 1, feststellen. Zu dem Linienfokus 23a ist außerdem eine Verbindungslinie 29 dargestellt, die durch die Enden des Linienfokus 23a innerhalb des Substratkörpers 21 verläuft. Dies kann als die gerade Fokallinie verstanden werden und die maximale Auslenkung von der geraden Fokallinie entspricht gerade dem Abstand zwischen der Verbindungslinie 29 und dem Scheitelpunkt 25.

Phasenfunktionen

Verschiedene exemplarische Phasenfunktionen, welche ein Laserstrahl aufgeprägt bekommen kann und gemäß denen die gekrümmten Wirkbereiche in einem Substratmaterial ausgebildet werden können, sind in der nachfolgenden Tabelle dargestellt:

| Beschleunigungsprofil | Phase |
|---|---|
| Parabolisch: $c(z) = az^2$ | $\phi(y) = -4/3\, a^{1/2}\, k\, y^{3/2}$ |
| Quartär: $c(z) = az^4$ | $\phi(y) = -16/21\, (3a)1/4\, k\, y^{7/4}$ |
| Logarithmisch : $c(z) = \alpha\, \ln(bz)$ | $\phi(y) = e^{-1}a^2b\, k\, (1-\exp[-y/a])$ |
| Polynomisch: $c(z) = az''$ (für gerades n) | $\phi(y) = kn^2 y^2 \dfrac{[a(1-n)/y]^{1/n}}{(2n-1)(1-n)}$ |

Die Parameter sind in der Veröffentlichung Froehly, L., Courvoisier, F., Mathis, A., Jacquot, M., Furfaro, L., Giust, R., ... & Dudley, J. M. (2011). Arbitrary accelerating micron-scale caustic beams in two and three dimensions. Optics express, 19(17), 16455-16465 beschrieben.

In den Figuren 12a-12c sind exemplarische Linienfoki für unterschiedliche Phasenfunktionen dargestellt. Die horizontale Achse hat jeweils die Einheit Millimeter (mm). Die vertikale Achse hat jeweils die Einheit Millimeter (mm). Figur 12a zeigt einen Laserstrahl, der einen Linienfokus mit einem parabolischen Beschleunigungsprofil aufweist. Figur 12b zeigt einen Laserstrahl, der einen Linienfokus mit einem quartären Beschleunigungsprofil aufweist. Figur 12c zeigt einen Laserstrahl, der einen Linienfokus mit einem logarithmischen Beschleunigungsprofil aufweist. Mit entsprechenden Linienfoki lassen sich unterschiedliche gekrümmte Wirkbereiche realisieren und damit das Substratmaterial in entsprechenden räumlichen Bereichen beeinflussen.

Der gesamte, theoretische Verlauf des Linienfokus gemäß der Phasenfunktion ist dabei jeweils gestrichelt dargestellt. Der Linienfokus selbst ist nur entlang eines Abschnitts ausgebildet (teilweise etwas versetzt, um den theoretischen Verlauf erkennen zu können). Nur dort wo der Linienfokus ausgebildet ist, kann eine nichtlineare Wechselwirkung stattfinden. Daran wird grundsätzlich verständlich, wie mit dem Linienfokus auch eine von außen zugängliche Kavität oder eine komplett eingeschlossene Kavität erhalten werden kann.

Die in der vorangehenden Beschreibung, in den Ansprüchen und in den Zeichnungen offenbarten Merkmale können sowohl einzeln als auch in beliebiger Kombination wesentlich für die Erfindung in ihren verschiedenen Ausführungsformen sein.

Bezugszeichenliste

| | |
|---|---|
| 1, 1', 1" | Substratkörper |
| 3 | Seitenfläche |
| 5, 5', 5" | Deckfläche |
| 7a-7c | gekrümmter Wirkbereich |
| 7', 7" | gekrümmter Wirkbereich |
| 9 | Kante |
| 11, 11', 11" | Deckfläche |
| 13 | Kontur |
| 15 | Substratmaterial |
| 17 | Oberfläche |
| 21 | Substratkörper |
| 23a-23e | Linienfokus |
| 25 | Scheitelpunkt |
| 27a, 27b | Bereich |
| 29 | Verbindungslinie |

S, S', S"      Schnittlinie

**Patentansprüche**

1. Verfahren zum Vorbereiten und/oder Durchführen der Strukturierung einer vorgegebenen oder vorgebbaren ausgezeichneten Oberfläche eines ein Substratmaterial aufweisenden Substratkörpers,
   wobei das Verfahren aufweist, das Substratmaterial in wenigstens einem gekrümmten Wirkbereichen einem elektromagnetischen Feld auszusetzen, das in jedem des wenigstens einen gekrümmten Wirkbereichs eine nichtlineare Wechselwirkung zwischen dem elektromagnetischen Feld und dem Substratmaterial hervorruft, und so das in dem gekrümmten Wirkbereich angeordnete Substratmaterial zumindest teilweise zu beeinflussen,
   wobei nach dem Strukturieren der ausgezeichneten Oberfläche die ausgezeichnete Oberfläche zumindest bereichsweise wenigstens einen ersten gekrümmten Verlauf aufweist, der durch die gekrümmte Gestalt des wenigstens einen gekrümmten Wirkbereichs zumindest teilweise bestimmt und/oder beeinflusst wird,
   wobei die nichtlineare Wechselwirkung wenigstens eine nichtlineare Absorption des elektromagnetischen Feldes im Substratmaterial hervorruft.

2. Verfahren nach Anspruch 1,
   wobei das Substratmaterial in mehreren gekrümmten Wirkbereichen einem elektromagnetischen Feld ausgesetzt wird,
   wobei vorzugsweise

   (i) die ausgezeichnete Oberfläche an mehreren Bereichen den gleichen ersten gekrümmten Verlauf aufweist, insbesondere bestimmt bzw. beeinflusst durch die gekrümmte Gestalt der mehreren gekrümmten Wirkbereiche, und/oder überall den ersten gekrümmten Verlauf aufweist,
   und/oder
   (ii) die gekrümmten Wirkbereiche beabstandet zueinander angeordnet gewählt werden, insbesondere in einer Querschnittsebene des Substratkörpers die Mittelpunkte oder Schwerpunkte der Schnittflächen der gekrümmten Wirkbereiche mit der Querschnittsebene entlang einer geraden Linie oder entlang einer beliebigen, insbesondere kreisförmigen, Kurve verlaufen und/oder aufeinanderfolgende Wirkbereiche einen Abstand zueinander aufweisen, der zwischen 30 % und 100 % oder zwischen 100 % und 200 % der maximalen Ausdehnung der gekrümmten Wirkbereiche in der Querschnittsebene beträgt.

3. Verfahren nach einem der vorangehenden Ansprüche,
   wobei das Beeinflussen des Substratmaterials aufweist, eine oder mehrere Materialeigenschaften, wie insbesondere den Brechungsindex, die Ätzrate und/oder die Dichte, des Substratmaterials zumindest bereichsweise zu verändern, insbesondere zu erhöhen oder zu verringern,
   und/oder
   wobei das Beeinflussen des Substratmaterials aufweist, das Substratmaterial zumindest teilweise aus dem gekrümmten Wirkbereich zu entfernen und/oder zu verdrängen, insbesondere das Substratmaterial in das umgebene Substratmaterial hineinzuverdichten.

4. Verfahren nach einem der vorangehenden Ansprüche,
   wobei die ausgezeichnete Oberfläche ausgebildet wird, indem durch das Beeinflussen das Substratmaterial zumindest teilweise entfernt wird und/oder indem wenigstens das beeinflusste Substratmaterial durch zumindest einen nachfolgenden Ätzvorgang, insbesondere nasschemisch, mittels einer Säure und/oder mittels einer Lauge, zumindest teilweise entfernt wird, wobei vorzugsweise als Ätzmedium eine Kalilauge eingesetzt wird.

5. Verfahren nach einem der vorangehenden Ansprüche,
   wobei das elektromagnetische Feld in Form eines und/oder durch einen gekrümmten Linienfokus, insbesondere eines Laserstrahls, bereitgestellt wird und/oder der gekrümmte Wirkbereich durch die Form des Linienfokus bestimmt wird.

6. Verfahren nach Anspruch 5,
   wobei der Laserstrahl durch einen Ultrakurzpulslaser bereitgestellt wird,
   wobei die Phase des Laserstrahls eingestellt und/oder angepasst wird, insbesondere mittels eines Spatial Light Modulators, eines diffraktives optischen Elements und/oder eine Kombination mehrerer Zylinderlinsen,
   wobei der Laserstrahl auf den Substratkörper fokussiert wird, vorzugsweise mittels eines Mikroskopobjektivs oder einer Fourierlinse, wobei das Fokussieren vorzugsweise nach dem Einstellen bzw. Anpassen der Phase des Laserstrahls erfolgt und/oder den Linienfokus ausbildet,

wobei der Linienfokus der eines beschleunigten Laserstrahls, insbesondere eines Airy-Strahls, ist,

wobei die Wellenlänge des Laserstrahls 1064 nm beträgt, das Mikroskopobjektiv bzw. die Fourierlinse eine Brennweite von 10-20 mm aufweist, der Koeffizient der kubischen Phase (Laser-Parameter Beta) einen Wert von zwischen $0{,}5 \times 10^3$/m und $5 \times 10^3$/m aufweist, der Durchmesser des Rohstrahls (Laser-Parameter $\omega_0$) einen Wert von zwischen 1 mm und 10 mm, vorzugsweise von zwischen 2,5 mm und 5 mm, aufweist, die Pulsdauer (Laser-Parameter $\tau$) einen Wert von 0,1-10 ps aufweist, die Pulsenergie (Laser-Parameter $E_p$) einen Wert von zwischen 1 und 1.500 $\mu$J, vorzugsweise von zwischen 30 und 500 $\mu$J, insbesondere 474 $\mu$J, aufweist, und/oder die Anzahl der Pulse im Burst (Laser-Parameter N) einen Wert von zwischen 1 und 200, vorzugsweise von zwischen 1 und 100, insbesondere von zwischen 1 und 8, aufweist,

wobei die räumliche Ausdehnung der gekrümmten Wirkbereiche, vorzugsweise ihre Länge und/oder ein ihrer Durchmesser, durch Variation des mittleren Leistungsbereichs des Lasers und/oder durch Phasenänderung eingestellt und/oder zeitlich verändert wird, insbesondere für zumindest einige der mehreren gekrümmten Wirkbereiche unterschiedliche Ausdehnungen eingestellt werden,

und/oder

wobei die räumliche Orientierung der gekrümmten Wirkbereiche durch Variation der Verkippung der optischen Achse des Laserstrahls gegenüber der Normalen der Substratoberfläche, insbesondere derjenigen Substratoberfläche, auf die der Laserstrahl auf den Substratkörper auftrifft, eingestellt und/oder zeitlich verändert wird, insbesondere für zumindest einige der mehreren gekrümmten Wirkbereiche unterschiedliche Orientierungen eingestellt werden.

7. Verfahren nach einem der Ansprüche 5 oder 6,
wobei zumindest während der nichtlinearen Wechselwirkung zumindest ein Hilfs-Substratkörper an dem Substratkörper angeordnet ist und sich der jeweilige gekrümmte Wirkbereich und/oder der Linienfokus zumindest teilweise in den Hilfs-Substratkörper hineinerstreckt, wobei vorzugsweise zwei oder mehr Hilfs-Substratkörper an dem Substratkörper angeordnet sind, insbesondere an gegenüberliegenden Seiten des Substratkörpers, und sich der jeweilige gekrümmte Wirkbereich und/oder der Linienfokus zumindest teilweise in zwei oder mehr Hilfs-Substratkörper hineinerstreckt.

8. Verfahren nach einem der vorangehenden Ansprüche,
wobei das Substratmaterial nacheinander oder ganz oder teilweise parallel in den einzelnen der mehreren gekrümmten Wirkbereichen dem elektromagnetischen Feld ausgesetzt wird,
wobei das gesamte Substratmaterial innerhalb eines gekrümmten Wirkbereichs gleichzeitig dem elektromagnetischen Feld ausgesetzt wird,
wobei die gekrümmten Wirkbereiche jeweils eine maximale Auslenkung von einem geraden Verlauf aufweisen, die mehr als 20 $\mu$m, mehr als 40 $\mu$m, mehr als 60 $\mu$m, mehr als 80 $\mu$m oder mehr als 100 $\mu$m beträgt,
und/oder
wobei die Länge der gekrümmten Wirkbereiche jeweils mehr als 0,1 mm, mehr als 0,3 mm, mehr als 0,5 mm, mehr als 0,7 mm, mehr als 1 mm, mehr als 3 mm oder mehr als 5 mm beträgt.

9. Verfahren nach einem der vorangehenden Ansprüche, wobei

(i) der Substratkörper transparent ist, aus Glas ist, eine erste Deckfläche aufweist und/oder eine zweite Deckfläche, die vorzugsweise parallel zur ersten Deckfläche verläuft und/oder ihr gegenüberliegt, aufweist,
(ii) die, vorzugsweise zwischen der ersten und zweiten Deckfläche gemessene, Dicke des Substratkörpers 500 $\mu$m oder weniger, vorzugsweise 400 $\mu$m oder weniger, noch bevorzugter 300 $\mu$m oder weniger, noch bevorzugter 200 $\mu$m oder weniger, noch bevorzugter 100 $\mu$m oder weniger, noch bevorzugter 70 $\mu$m oder weniger, noch bevorzugter 50 $\mu$m oder weniger, noch bevorzugter 30 $\mu$m oder weniger, am bevorzugtesten 10 $\mu$m oder weniger, beträgt,
und/oder
(iii) nach dem Strukturieren der ausgezeichneten Oberfläche

1. die ausgezeichnete Oberfläche zwischen der ersten und zweiten Deckfläche verläuft,
2. die ausgezeichnete Oberfläche mit der ersten und/oder der zweiten Deckfläche zumindest bereichsweise verbunden ist,
3. zumindest ein Teil zumindest einer Seitenfläche, vorzugsweise einer umlaufenden Seitenfläche, des Substratkörpers die ausgezeichnete Oberfläche aufweist,

4. zumindest ein Teil einer Oberfläche eines Durchgangsloches, das sich vorzugsweise von der ersten Deckfläche zur zweiten Deckfläche erstreckt, die ausgezeichnete Oberfläche aufweist, und vorzugsweise das Durchgangsloch durch das Beeinflussen und/oder Ätzen des Substratmaterials ausgebildet wird,

5. zumindest ein Oberflächenbereich einer Kavität des Substratkörpers die ausgezeichnete Oberfläche aufweist, wobei die Kavität vorzugsweise von außen zugänglich ist oder komplett in dem Substratmaterial eingeschlossen ist, und vorzugsweise die Kavität durch das Beeinflussen und/oder Ätzen des Substratmaterials ausgebildet wird,

6. die ausgezeichnete Oberfläche zumindest bereichsweise eine nach innen zeigende Oberfläche des Substratkörpers darstellt,

und/oder

7. die ausgezeichnete Oberfläche zumindest bereichsweise eine nach außen zeigende Oberfläche des Substratkörpers darstellt.

10. Verfahren nach einem der vorangehenden Ansprüche,

wobei nach dem Strukturieren der ausgezeichneten Oberfläche sich der erste gekrümmte Verlauf der ausgezeichneten Oberfläche senkrecht zur Haupterstreckungsrichtung der ausgezeichneten Oberfläche erstreckt,

und/oder

wobei in Haupterstreckungsrichtung der ausgezeichneten Oberfläche, insbesondere in umfänglicher Richtung des Substratkörpers, die ausgezeichnete Oberfläche zumindest bereichsweise einen zweiten gekrümmten Verlauf aufweist.

11. Verfahren nach einem der vorangehenden Ansprüche,

wobei nach dem Strukturieren der ausgezeichneten Oberfläche in wenigstens einer Querschnittsebene des Substratkörpers die ausgezeichnete Oberfläche eine Kontur aufweist, die entlang des ersten gekrümmten Verlaufs

(i) zumindest abschnittsweise konvex oder konkav gekrümmt ist,

(ii) zumindest abschnittsweise einer Kontur des gekrümmten Wirkbereichs entspricht,

und/oder

(iii) zumindest abschnittsweise einen parabolischen Verlauf, einen quartischen Verlauf, einen logarithmischen Verlauf, einen Verlauf gemäß einer polynomialen Funktion des Grades n, vorzugsweise mit geradem n, insbesondere mit n=6, n=8, n=10 oder n=12, und/oder einen C-förmigen Verlauf aufweist.

12. Substratkörper,

aufweisend wenigstens eine erste Deckfläche und wenigstens eine, insbesondere mit einem Verfahren nach einem der vorangehenden Ansprüche hergestellte oder herstellbare, ausgezeichnete Oberfläche,

wobei die ausgezeichnete Oberfläche zumindest bereichsweise wenigstens einen ersten gekrümmten Verlauf aufweist,

wobei der erste gekrümmte Verlauf in einer Querschnittsebene des Substratkörpers liegt, die durch eine Ebene, die wenigstens einen Normalenvektor der ausgezeichneten Oberfläche und einen Normalenvektor der Deckfläche aufweist, aufgespannt wird,

wobei der erste gekrümmte Verlauf zumindest bereichsweise durch eine parabolische, quartäre, logarithmische und/oder polynomische Phasenfunktion beschrieben werden kann,

wobei der Substratkörper eine Dicke von 500 μm oder weniger aufweist.

13. Substratkörper nach Anspruch 12,

wobei die ausgezeichnete Oberfläche eine Festigkeit von wenigstens 100 MPa, vorzugsweise von wenigstens 150 MPa, noch bevorzugter von wenigstens 200 MPa, aufweist,

wobei vorzugsweise die ausgezeichnete Oberfläche ganz oder teilweise geätzt wurde, insbesondere mit Flusssäure, Natriumhydroxid, einer Lauge, wie einer Kalilauge, und/oder einer Säure.

14. Substratkörper nach einem der Ansprüche 12 bis 13,

wobei die ausgezeichnete Oberfläche zumindest bereichsweise höhenmoduliert ist, insbesondere eine wellenartige und/oder kalottenförmige Struktur aufweist, vorzugsweise entlang der Haupterstreckungsrichtung der ausgezeichneten Oberfläche und/oder senkrecht dazu.

15. Substratkörper nach einem der Ansprüche 12 bis 14, wobei

(i) der Substratkörper transparent ist, aus Glas ist und/oder eine zweite Deckfläche, die vorzugsweise parallel zur ersten Deckfläche verläuft und/oder ihr gegenüberliegt, aufweist,

(ii) die, vorzugsweise zwischen der ersten und zweiten Deckfläche gemessene, Dicke des Substratkörpers 500 $\mu$m oder weniger, vorzugsweise 400 $\mu$m oder weniger, noch bevorzugter 300 $\mu$m oder weniger, noch bevorzugter 200 $\mu$m oder weniger, noch bevorzugter 100 $\mu$m oder weniger, noch bevorzugter 70 $\mu$m oder weniger, noch bevorzugter 50 $\mu$m oder weniger, noch bevorzugter 30 $\mu$m oder weniger, am bevorzugtesten 10 $\mu$m oder weniger, beträgt,

und/oder

(iii)

1. die ausgezeichnete Oberfläche zwischen der ersten und zweiten Deckfläche verläuft,

2. die ausgezeichnete Oberfläche mit der ersten und/oder der zweiten Deckfläche zumindest bereichsweise verbunden ist,

3. zumindest ein Teil zumindest einer Seitenfläche, vorzugsweise einer umlaufenden Seitenfläche, des Substratkörpers die ausgezeichnete Oberfläche aufweist,

4. zumindest ein Teil einer Oberfläche eines Durchgangsloches, das sich vorzugsweise von der ersten Deckfläche zur zweiten Deckfläche erstreckt, die ausgezeichnete Oberfläche aufweist, und vorzugsweise das Durchgangsloch durch Beeinflussen und/oder Ätzen des Substratmaterials ausgebildet ist,

5. zumindest ein Oberflächenbereich einer Kavität des Substratkörpers die ausgezeichnete Oberfläche aufweist, wobei die Kavität vorzugsweise von außen zugänglich ist oder komplett in dem Substratmaterial eingeschlossen ist, und vorzugsweise die Kavität durch Beeinflussen und/oder Ätzen des Substratmaterials ausgebildet ist,

6. die ausgezeichnete Oberfläche zumindest bereichsweise eine nach innen zeigende Oberfläche des Substratkörpers darstellt,

und/oder

7. die ausgezeichnete Oberfläche zumindest bereichsweise eine nach außen zeigende Oberfläche des Substratkörpers darstellt.

**16.** Substratkörper nach einem der Ansprüche 12 bis 15,

wobei sich der erste gekrümmte Verlauf der ausgezeichneten Oberfläche senkrecht zur Haupterstreckungsrichtung der ausgezeichneten Oberfläche erstreckt,

und/oder

wobei in Haupterstreckungsrichtung der ausgezeichneten Oberfläche, insbesondere in umfänglicher Richtung des Substratkörpers, die ausgezeichnete Oberfläche zumindest bereichsweise einen zweiten gekrümmten Verlauf aufweist.

**17.** Verfahren nach einem der vorangehenden Ansprüche,

wobei in wenigstens einer Querschnittsebene des Substratkörpers die ausgezeichnete Oberfläche eine Kontur aufweist, die entlang des ersten gekrümmten Verlaufs

(i) zumindest abschnittsweise konvex oder konkav gekrümmt ist,

(ii) zumindest abschnittsweise einer Kontur des gekrümmten Wirkbereichs entspricht,

und/oder

(iii) zumindest abschnittsweise einen parabolischen Verlauf, einen quartischen Verlauf, einen logarithmischen Verlauf, einen Verlauf gemäß einer polynomialen Funktion des Grades n, vorzugsweise mit geradem n, insbesondere mit n=6, n=8, n=10 oder n=12, und/oder einen C-förmigen Verlauf aufweist.

**18.** Substratkörper, vorzugsweise nach einem der Ansprüche 12 bis 17,

wobei der Substratkörper zumindest bereichsweise wenigstens eine räumliche Modifikation seines Substratmaterials, wie eine Änderung des Brechungsindex, eine Änderung der Dichte und/oder einen Hohlraum, aufweist,

wobei die Modifikation in einer Querschnittsebene des Substratkörpers zumindest bereichsweise eine gekrümmte Kontur aufweist,

wobei vorzugsweise sich die Modifikation von einer ersten Deckfläche des Substratkörpers in das Substratmaterial hinein erstreckt, insbesondere in Richtung und/oder bis zu einer, vorzugsweise der ersten Deckfläche gegenüberliegenden und/oder parallel zu dieser verlaufenden, zweiten Deckfläche des Substratkörpers,

wobei vorzugsweise der Substratkörper eine Dicke von 500 $\mu$m oder weniger aufweist, die insbesondere zwischen der ersten und der zweiten Deckfläche des Substratkörpers gemessen wird.

**19.** Substratkörper nach Anspruch 18,
wobei die Modifikation eine maximale Auslenkung von einem geraden Verlauf aufweist, die mehr als 20 $\mu$m, mehr als 40 $\mu$m, mehr als 60 $\mu$m, mehr als 80 $\mu$m oder mehr als 100 $\mu$m beträgt,
und/oder
wobei die Länge der Modifikation jeweils mehr als 0,1 mm, mehr als 0,3 mm, mehr als 0,5 mm, mehr als 0,7 mm, mehr als 1 mm, mehr als 3 mm oder mehr als 5 mm beträgt.

1

5

3

Fig. 1

1

S

7a

3

7b

9

7c

Fig. 2

Fig. 3

Fig. 4a

Fig. 4b

Fig. 5

Fig. 6a

Fig. 6b

Fig. 7a

Fig. 7b

Fig. 8a

Fig. 8b

Fig. 9

Fig. 10

Fig. 11

Fig. 12a

Fig. 12b

Fig. 12c

Europäisches
Patentamt

European
Patent Office

Office européen
des brevets

# EUROPÄISCHER RECHERCHENBERICHT

Nummer der Anmeldung

EP 20 19 4675

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2017/252859 A1 (KUMKAR MALTE [DE] ET AL) 7. September 2017 (2017-09-07) | 1-3,5-19 | INV. B23K26/53 B23K26/06 B23K26/073 B23K26/0622 B81C1/00 |
| Y | * Absätze [0071] - [0076], [0078], [0101], [0189], [0194], [0203] - [0207] * | 4 | |
| | ----- | | |
| X | US 2017/259375 A1 (KUMKAR MALTE [DE] ET AL) 14. September 2017 (2017-09-14) | 1-3,5-19 | ADD. B23K103/00 |
| Y | * Absätze [0055] - [0056], [0104], [0188] * | 4 | |
| | ----- | | |
| X | US 2019/062196 A1 (BUI DUC ANH [DE]) 28. Februar 2019 (2019-02-28) * Absätze [0114], [0115], [0094] * | 1-3,5-11 | |
| | ----- | | |
| Y | JP 2018 070429 A (USHIO ELECTRIC INC) 10. Mai 2018 (2018-05-10) * Absätze [0015] - [0017] * | 4 | |
| | ----- | | |

RECHERCHIERTE SACHGEBIETE (IPC)

B23K
B82B
B81C

Der vorliegende Recherchenbericht wurde für alle Patentansprüche erstellt

| Recherchenort | Abschlußdatum der Recherche | Prüfer |
|---|---|---|
| München | 8. März 2021 | Hernanz, Sonsoles |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 19 4675

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-03-2021

| Im Recherchenbericht angeführtes Patentdokument | Datum der Veröffentlichung | Mitglied(er) der Patentfamilie | Datum der Veröffentlichung |
|---|---|---|---|
| US 2017252859 A1 | 07-09-2017 | CN 107003531 A<br>EP 3221727 A1<br>KR 20170102467 A<br>KR 20200090967 A<br>US 2017252859 A1<br>WO 2016079275 A1 | 01-08-2017<br>27-09-2017<br>11-09-2017<br>29-07-2020<br>07-09-2017<br>26-05-2016 |
| US 2017259375 A1 | 14-09-2017 | CN 107003530 A<br>CN 111992873 A<br>DE 102014116957 A1<br>EP 3221740 A1<br>EP 3799999 A1<br>KR 20170086594 A<br>TW 201626050 A<br>US 2017259375 A1<br>US 2020316711 A1<br>WO 2016079062 A1 | 01-08-2017<br>27-11-2020<br>19-05-2016<br>27-09-2017<br>07-04-2021<br>26-07-2017<br>16-07-2016<br>14-09-2017<br>08-10-2020<br>26-05-2016 |
| US 2019062196 A1 | 28-02-2019 | CN 111065485 A<br>EP 3672755 A1<br>JP 2020531392 A<br>KR 20200049800 A<br>TW 201919805 A<br>US 2019062196 A1<br>WO 2019040854 A1 | 24-04-2020<br>01-07-2020<br>05-11-2020<br>08-05-2020<br>01-06-2019<br>28-02-2019<br>28-02-2019 |
| JP 2018070429 A | 10-05-2018 | KEINE | |

EPO FORM P0461

Für nähere Einzelheiten zu diesem Anhang : siehe Amtsblatt des Europäischen Patentamts, Nr.12/82

**EP 3 964 323 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FROEHLY, L. ; COURVOISIER, F. ; MATHIS, A. ; JACQUOT, M. ; FURFARO, L. ; GIUST, R. ; DUDLEY, J. M.** Arbitrary accelerating micron-scale caustic beams in two and three dimensions. *Optics express,* 2011, vol. 19 (17), 16455-16465